# EUROPEAN PATENT SPECIFICATION

(11) **EP 4 318 183 B1**
(45) Date of publication and mention of the grant of the patent: **15.10.2025**
(21) Application number: 23709098.0
(22) Date of filing: 08.03.2023
(51) Int. Cl.: G06F 1/16, H04M 1/02

(54) **ELECTRONIC DEVICE COMPRISING HINGE STRUCTURE FOR FOLDING DISPLAY**
ELEKTRONISCHE VORRICHTUNG MIT SCHARNIERSTRUKTUR FÜR KLAPPBARE ANZEIGE
DISPOSITIF ÉLECTRONIQUE COMPRENANT UNE STRUCTURE CHARNIÈRE POUR UN AFFICHAGE PLIABLE

(30) Priority: 20.06.2022 KR 20220074991; 25.07.2022 KR 20220092036
(43) Date of publication of application: 07.02.2024
(73) Proprietor: Samsung Electronics Co., Ltd., Suwon-si, Gyeonggi-do 16677 (KR)
(72) Inventor: CHOI, Sooyeon, Suwon-si, Gyeonggi-do 16677 (KR); KIM, Jaehee, Suwon-si, Gyeonggi-do 16677 (KR)
(74) Representative: HGF
(86) International application number: PCT/KR2023/003205
(87) International publication number: WO 2023/249204

(56) References cited:
- WO-A1-2021/112549
- WO-A1-2021/115462
- WO-A1-2021/129882
- WO-A1-2022/119353
- CN-A- 113 067 923
- CN-A- 113 194 183
- CN-A- 113 299 195
- CN-U- 216 241 794
- KR-A- 20210 068 880
- KR-A- 20220 038 036
- KR-A- 20220 067 310
- US-A1- 2021 271 294
- US-A1- 2021 368 032

## Description

### [Technical Field]

The present disclosure relates to an electronic device including a hinge structure for folding a display.

### [Background Art]

There is an increasing need for an electronic device in which a size of a display for displaying contents may be changed so that a user may receive various contents through the electronic device. For example, the electronic device may provide a structure in which the size of the display for displaying the contents may be changed as it includes a foldable flexible display.

WO 2021/112549 A1 discloses, according to its abstract, an electronic device including a hinge assembly. The electronic device includes a first housing, a second housing, a hinge assembly coupling the first housing and the second housing so that the second housing is rotatable with respect to the first housing, and a flexible display disposed from one region of the first housing to at least one region of the second housing across the hinge assembly. The hinge assembly includes a first bracket coupled to at least one region of the first housing to rotate about a virtual first rotation axis, a second bracket coupled to at least one region of the second housing to rotate about a virtual second rotation axis, a fixing bracket supporting the first bracket and the second bracket, a first shaft rotating about a third rotation axis different from the virtual first rotation axis, a second shaft adjacent to the first shaft to rotate about a fourth rotation axis different from the virtual second rotation axis, a first arm portion coupled to the first shaft to rotate about the third rotation axis, and having one side coupled to at least one region of the first bracket, a second arm portion coupled to the second shaft to rotate about the fourth rotation axis, and having one side coupled to at least one region of the second bracket, and a support portion located between the first arm portion and the second arm portion. The support portion supports at least one region of the flexible display when the electronic device is in an unfolded state, and is spaced apart from the flexible display as the electronic device rotates from the unfolded state to a folded state.

### [Disclosure]

### [Technical Problem]

An electronic device may include a hinge structure that rotates a housing for folding of a display. As the folding of the display by the hinge structure is repeated, a wrinkle (or crease), caused by the folding, may be formed on the display. In order to reduce forming of the wrinkle on the display, the hinge structure may include a supporting member that is rotatable based on a rotational axis different from that of the housing to have a rotation angle different from that of the housing and supports the display. As the rotational axes of the housing and the supporting member are different from each other, various problems may occur while the display is folded. For example, in case that the rotational axis of the housing is fixed, stress is generated by a change in a distance between the housing and the supporting member, and thus damage to the display due to the stress may occur. In case that the rotational axis of the housing is changed or variable, rotation of the housing may become unstable while the display is folded or being folded. The electronic device may need a structure that may more stably fold the display and/or may reduce damage to the display while the display is folded or being folded.

The technical problems to be achieved (solved, addressed or mitigated) in this document are not limited to those described above, and other technical problems not mentioned herein will be clearly understood by those having ordinary knowledge in the art to which the present disclosure belongs, from the following description.

### [Technical Solution]

The scope of the present invention is determined according to the independent claim. Various embodiments of the present invention are outlined in the dependent claims.

According to an embodiment, an electronic device comprises a first housing including a first surface and a second surface opposite to the first surface; a second housing including a third surface and a fourth surface opposite to the third surface; a hinge structure changeable to a folded state in which the first surface faces the third surface, or an unfolded state in which a direction the first surface is facing is the same as a direction the third surface is facing, by rotatably connecting the first housing and the second housing; and a display disposed on the first surface and the third surface across the hinge structure. According to an embodiment, the hinge structure includes a hinge bracket including a rotary rail and a guide rail spaced apart from the rotary rail. According to an embodiment, the hinge structure includes a rotating member coupled to the first housing, rotatable based on a first rotational axis along the rotary rail by a movement of the first housing, and including a sliding pin. According to an embodiment, the hinge structure includes a supporting member supporting a one surface of the display, and including a sliding opening slidable with respect to the sliding pin, and a guide groove guided by the guide rail. According to an embodiment, the supporting member is rotatable along the guide rail by the sliding of the sliding opening, based on a second rotational axis distinct from the first rotational axis. According to an embodiment, a width of one end of the guide groove is bigger than a width of the other end of the guide groove facing the one surface of the display.

According to an embodiment, an electronic device comprises a first housing; a second housing rotatable with respect to the first housing; a hinge structure disposed between the first housing and the second housing, and changeable to a folded state in which a one surface of the first housing faces a one surface of the second housing, or an unfolded state in which a direction the one surface of the first housing facing and a direction the one surface of the second housing facing are same each other; and a display including a first display region disposed on the first housing and a second display region disposed on the second housing and a third display region disposed on the hinge structure. According to an embodiment, the hinge structure includes a hinge bracket including a rotary rail and a guide rail spaced apart from the rotary rail. According to an embodiment, the hinge structure includes a rotating member including a sliding pin, coupled to the first housing and rotatable based on a first rotational axis along the rotary rail by the movement of the first housing. According to an embodiment, the hinge structure includes a supporting member including a sliding opening slidable with respect to the sliding pin and a guide groove guided by the guide rail, and the supporting member supports a one surface of the third display region. According to an embodiment, the supporting member is rotatable along the guide rail based on a second rotational axis distinct from the first rotational axis by the sliding of the sliding opening, the supporting member may be rotatable within an angle range bigger than an angle range of the rotating member. According to an embodiment, a width of one end of the guide groove may be bigger than a width of the other end of the guide groove facing the one surface of the third display region. According to an embodiment, a part of the third display region may be supported by the supporting member and may be inclined with respect to the first display region when the folded state.

### [Advantageous Effects]

An electronic device according to an embodiment can provide a structure that can stably fold a display and can reduce damage to the display while the display is folded, (or being folded) by a hinge structure that rotates a housing and a supporting member supporting the display based on different rotational axes.

The effects that can be obtained from the present disclosure are not limited to those described above, and any other effects not mentioned herein will be clearly understood by those having ordinary knowledge in the art to which the present disclosure belongs, from the following description.

### [Description of the Drawings]

FIG. 1 is a block diagram of an electronic device in a network environment according to various embodiments.
FIG. 2A illustrates an example of an unfolded state of an electronic device according to an embodiment.
FIG. 2B illustrates an example of a folded state of an electronic device according to an embodiment.
FIG. 2C is an exploded view of an electronic device according to an embodiment.
FIG. 3A is a top plan view of an electronic device according to an embodiment.
FIG. 3B is an enlarged view enlarging a hinge structure of an electronic device according to an embodiment.
FIG. 3C is an exploded perspective view of an electronic device according to an embodiment.
FIG. 3D is a cross-sectional view illustrating an example in which a hinge structure of an electronic device according to an embodiment is cut along A-A' of FIG. 3B.
FIG. 3E is a cross-sectional view illustrating another example in which a hinge structure of an electronic device according to an embodiment is cut along A-A' of FIG. 3B.
FIG. 3F is a cross-sectional view illustrating the other example in which a hinge structure of an electronic device according to an embodiment is cut along A-A' of FIG. 3B.
FIG. 4A is a cross-sectional view illustrating an example in which a hinge structure of an electronic device according to an embodiment is cut along B-B' of FIG. 3B.
FIG. 4B is a cross-sectional view illustrating another example in which a hinge structure of an electronic device according to an embodiment is cut along B-B' of FIG. 3B.
FIG. 4C is a cross-sectional view illustrating the other example in which a hinge structure of an electronic device according to an embodiment is cut along B-B' of FIG. 3B.
FIG. 5A is a cross-sectional view illustrating an example in which a hinge structure of an electronic device according to an embodiment is cut along C-C' of FIG. 3B.
FIG. 5B is a cross-sectional view illustrating another example in which a hinge structure of an electronic device according to an embodiment is cut along C-C' of FIG. 3B.
FIG. 5C is a cross-sectional view illustrating the other example in which a hinge structure of an electronic device according to an embodiment is cut along C-C' of FIG. 3B.

### [Mode for Invention]

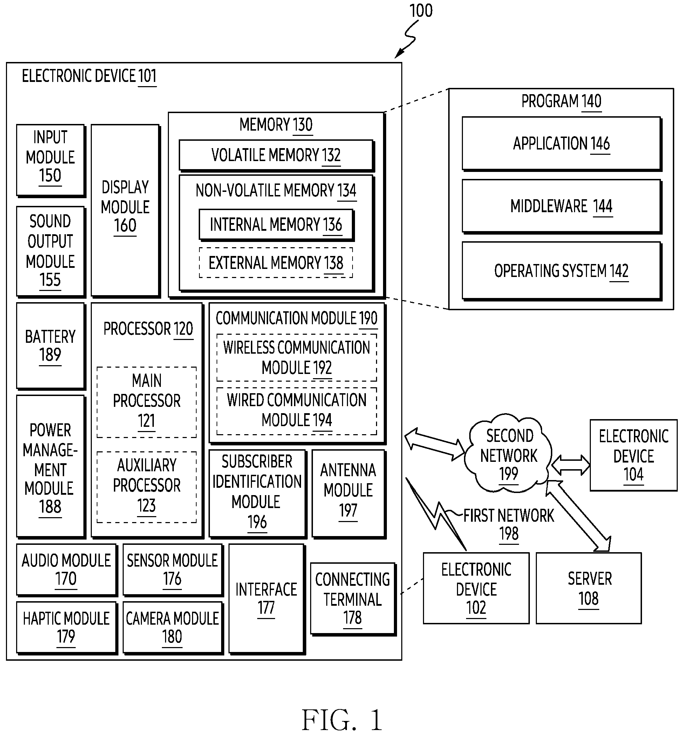

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

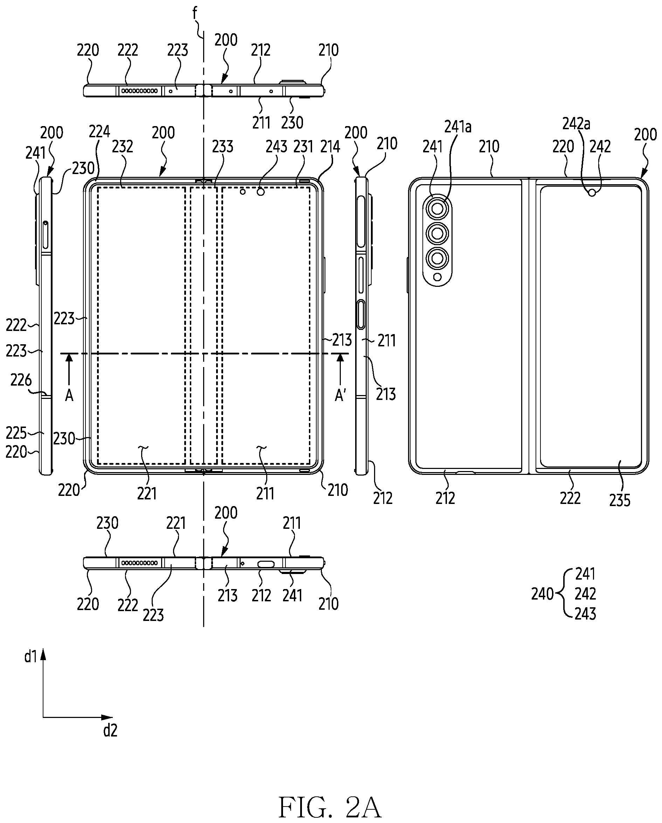

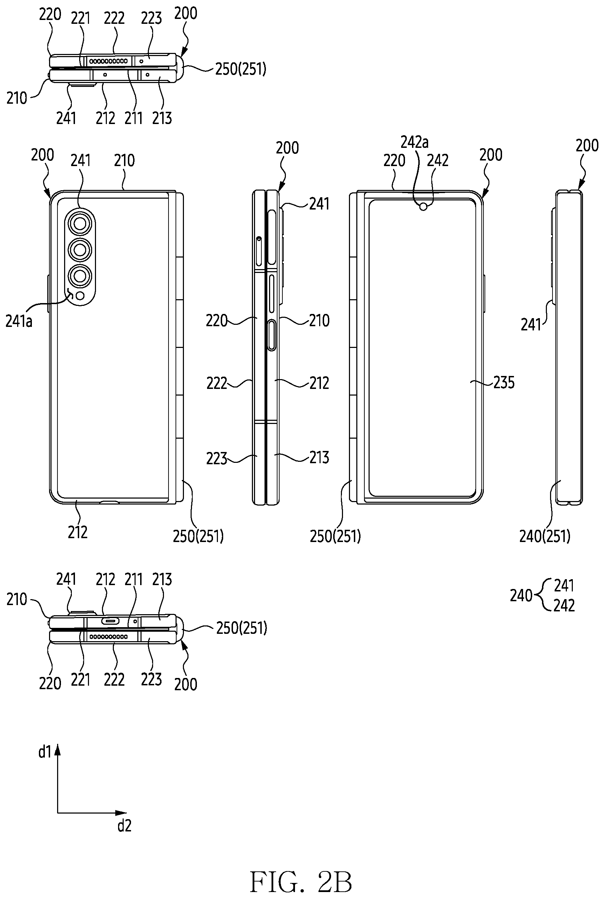

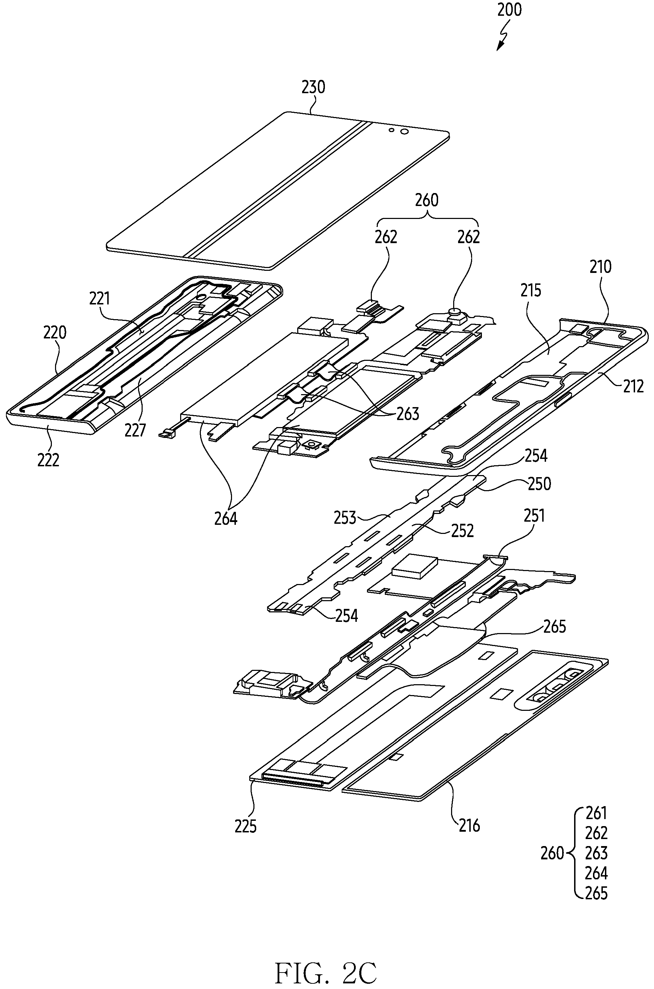

FIG. 2A illustrates an example of an unfolded state of an electronic device according to an embodiment, FIG. 2B illustrates an example of a folded state of an electronic device according to an embodiment, and FIG. 2C is an exploded view of an electronic device according to an embodiment.

Referring to FIGS. 2A, 2B, and 2C, an electronic device 200 (e.g., an electronic device 101 of FIG. 1) includes a first housing 210, a second housing 220, a display 230 (e.g., a display module 160 of FIG. 1), and a hinge structure 250. The electronic device may further include at least one camera 240, and/or at least one electronic component 260.

The first housing 210 and the second housing 220 may form at least a part of an outer surface of the electronic device 200 that may be gripped by a user. At least the part of the outer surface of the electronic device 200 defined by the first housing 210 and the second housing 220, when the electronic device 200 is used by the user, may contact a part of the user's body. The first housing 210 includes a first surface 211 and a second surface 212 facing the first surface 211 and spaced apart from the first surface 211. The first housing 210 may include a first side surface 213 surrounding at least a part of the first surface 211 and the second surface 212. The first side surface 213 may connect a periphery of the first surface 211 and a periphery of the second surface 212. The first surface 211, the second surface 212, and the first side surface 213 may define an inner space of the first housing 210. According to an embodiment, the first housing 210 may provide a space formed by the first surface 211, the second surface 212, and the first side surface 213 as a space for disposing components of the electronic device 101.

The second housing 220 includes a third surface 221 and a fourth surface 222 facing the third surface 221 and spaced apart from the third surface 221. The second housing 220 may include a second side surface 223 surrounding at least a part of the third surface 221 and the fourth surface 222. The second side surface 223 may connect a periphery of the third surface 221 and a periphery of the fourth surface 222. The third surface 221, the fourth surface 222, and the second side surface 223 may define an inner space of the second housing 220. According to an embodiment, the second housing 220 may provide a space formed by the third surface 221, the fourth surface 222, and the second side surface 223 surrounding at least a part of the third surface 221 and the fourth surface 222 as the space for disposing components of the electronic device 101. According to an embodiment, the second housing 220 may be coupled to the first housing 210 so as to be rotatable with respect to the first housing 210.

According to an embodiment, each of the first housing 210 and the second housing 220 may include a first protecting member 214 and a second protecting member 224, respectively. The first protecting member 214 and the second protecting member 224 may be disposed on the first surface 211 and the third surface 221 along the periphery of the display 230. According to an embodiment, the first protecting member 214 and the second protecting member 224 may prevent an inflow of a foreign substance (e.g., dust or moisture) through a gap between the display 230 and the first housing 210 and the second housing 220. For example, the first protecting member 214 may surround a periphery of a first display region 231 of the display 230, and the second protecting member 224 may surround a periphery of a second display region 232 of the display 230. The first protecting member 214 may be formed by being attached to the first side surface 213 of the first housing 210 or may be integrally formed with the first side surface 213. The second protecting member 224 may be formed by being attached to the second side surface 223 of the second housing 220 or may be integrally formed with the second side surface 223.

According to an embodiment, the first side surface 213 and the second side surface 223 may include a conductive material, a non-conductive material, or a combination thereof. For example, the second side surface 223 may include at least one conductive member 225 and at least one non-conductive member 226. The at least one conductive member 225 may include a plurality of conductive members spaced apart from each other, respectively. The at least one non-conductive member 226 may be disposed between the plurality of conductive members. By the at least one non-conductive member 226 disposed between the plurality of conductive members, the plurality of conductive members may be disconnected from each other. According to an embodiment, the plurality of conductive members and a plurality of non-conductive members may together form an antenna radiator. The electronic device 200 may communicate with an external electronic device through the antenna radiator formed by the plurality of conductive members and the plurality of non-conductive members.

The display 230 may be configured to display visual information. The display 230 is disposed on the first surface 211 of the first housing 210 and the third surface 221 of the second housing 220 across the hinge structure 250. For example, the display 230 may include the first display region 231 disposed on the first surface 211 of the first housing, the second display region 232 disposed on the third surface 221 of the second housing, and a third display region 233 disposed between the first display region 231 and the second display region 232. The first display region 231, the second display region 232, and the third display region 233 may form a front surface of the display 230. According to an embodiment, the display 230 may further include a sub-display panel 235 disposed on the fourth surface 222 of the second housing 220. According to an embodiment, the display 230 may include a window exposed toward outside of the electronic device 200. The window may protect a surface of the display 230 and transmit the visual information provided by the display 230 to the outside of the electronic device 200 by including a substantially transparent material. For example, the window may include glass (e.g., UTG, ultrathin glass) and/or polymer (e.g., PI, polyimide), but is not limited thereto.

The at least one camera 240 may be configured to obtain an image based on receiving light from an external subject of the electronic device 200. According to an embodiment, the at least one camera 240 may include first cameras 241, a second camera 242, and a third camera 243. The first cameras 241 may be disposed in the first housing 210. For example, the first cameras 241 may be disposed inside the first housing 210, and at least a part thereof may be visible through the second surface 212 of the first housing 210. The first cameras 241 may be supported by a bracket (not illustrated) in the first housing 210. The first housing 210 may include at least one opening 241a overlapping the first cameras 241 when the electronic device 200 is viewed from above. The first cameras 241 may obtain the image based on receiving the light from the outside of the electronic device 200 through the at least one opening 241a.

According to an embodiment, the second camera 242 may be disposed in the second housing 220. For example, the second camera 242 may be disposed inside the second housing 220 and may be visible through the sub-display panel 235. The second housing 220 may include the at least one opening 242a overlapping the second camera 242 when the electronic device 200 is viewed from above. The second camera 242 may obtain the image based on receiving the light from the outside of the electronic device 200 through the at least one opening 242a.

According to an embodiment, the third camera 243 may be disposed in the first housing 210. For example, the third camera 243 may be disposed inside the first housing 210, and at least a part thereof may be visible through the first surface 211 of the first housing 210. For another example, the third camera 243 may be disposed inside the first housing 210, and at least the part thereof may be visible through the first display region 231 of the display 230. The first display region 231 of the display 230 may include at least one opening overlapping the third camera 243 when the display 230 is viewed from above. The third camera 243 may obtain the image based on receiving the light from outside of the display 230 through the at least one opening.

According to an embodiment, the second camera 242 and the third camera 243 may be disposed under the display 230 (e.g., direction toward inside of the first housing 210 or inside of the second housing 220). For example, the second camera 242 and the third camera 243 may be an under display camera (UDC). In case that the second camera 242 and the third camera 243 are the under display camera, one region of the display 230 corresponding to a respective position of the second camera 242 and the third camera 243 may not be an inactive region. The inactive region of the display 230 may mean the one region of the display 230 that does not include a pixel or dose not emit the light to the outside of the electronic device 200. For another example, the second camera 242 and the third camera 243 may be a punch hole camera. In case that the second camera 242 and the third camera 243 are the punch hole camera, the one region of the display 230 corresponding to the respective position of the second camera 242 and the third camera 243 may be the inactive region.

The hinge structure 250 rotatably connects the first housing 210 and the second housing 220. The hinge structure 250 may be disposed between the first housing 210 and the second housing 220 of the electronic device 101 so that the electronic device 200 may be curved, bent, or folded. For example, the hinge structure 250 may be disposed between a part of the first side surface 213 and a part of the second side surface 223 facing each other. The hinge structure 250 may change the electronic device 200 to the unfolded state in which a direction the first surface 211 of the first housing 210 facing and a direction the third surface 221 of the second housing 220 facing are the same or the folded state in which the first surface 211 and the third surface 221 face each other. When the electronic device 200 is in the folded state, the first housing 210 and the second housing 220 may be piled up or overlapped by facing each other.

According to an embodiment, when the electronic device 200 is in the folded state, the direction the first surface 211 facing and the direction the third surface 221 facing may be different from each other. For example, when the electronic device 200 is in the folded state, the direction the first surface 211 facing and the direction the third surface 221 facing may be opposite to each other. For another example, when the electronic device 200 is in the folded state, the direction the first surface 211 facing and the direction the third surface 221 facing may be inclined with respect to each other. When the direction the first surface 211 facing is inclined with respect to the direction the third surface 221 facing, the first housing 210 may be inclined with respect to the second housing 220.

According to an embodiment, the electronic device 200 may be foldable based on a folding axis f. The folding axis f may mean an imaginary line passing through a hinge cover 251 and extending in a direction parallel to a perpendicular direction of the electronic device 200 (e.g., d1 of FIGS. 2A and 2B), but is not limited thereto. For example, the folding axis f may be an imaginary line extending in a direction perpendicular to the longitudinal direction of the electronic device 200 (e.g., d2 of FIGS. 2A and 2B). In case that the folding axis f extends in the direction perpendicular to the longitudinal direction of the electronic device 200, the hinge structure 250 may extend in a direction parallel to the folding axis f to connect the first housing 210 and the second housing 220. The first housing 210 and the second housing 220 may be rotatable by the hinge structure 250 extending in the direction perpendicular to the longitudinal direction of the electronic device 200.

According to an embodiment, the hinge structure 250 may include the hinge cover 251, a first hinge plate 252, a second hinge plate 253, and a hinge module 254. The hinge cover 251 may surround internal components of the hinge structure 250 and may form an outer surface of the hinge structure 250. According to an embodiment, at least a part of the hinge cover 251 surrounding the hinge structure 250 may be exposed to the outside of the electronic device 200 through between the first housing 210 and the second housing 220 when the electronic device 200 is in the folded state. According to an embodiment, when the electronic device 200 is in the unfolded state, the hinge cover 251 may not be exposed to the outside of the electronic device 200 by being covered by the first housing 210 and the second housing 220.

According to one embodiment, the first hinge plate 252 and the second hinge plate 253, by being coupled to the first housing 210 and the second housing 220, respectively, may rotatably connect the first housing 210 and the second housing 220. For example, the first hinge plate 252 may be coupled to a first front bracket 215 of the first housing 210, and the second hinge plate 253 may be coupled to a second front bracket 227 of the second housing 220. As the first hinge plate 252 and the second hinge plate 253 are coupled to the first front bracket 215 and the second front bracket 227, respectively, the first housing 210 and the second housing 220 may be rotatable according to rotation of the first hinge plate 252 and the second hinge plate 253.

The hinge module 254 may rotate the first hinge plate 252 and the second hinge plate 253. For example, the hinge module 254 may include gears that may be engaged with each other and rotatable to rotate the first hinge plate 252 and the second hinge plate 253 with respect to the folding axis f. According to an embodiment, the hinge module 254 may be plural. For example, each of the plurality of hinge modules 254 may be disposed spaced apart from each other at both ends of the first hinge plate 252 and the second hinge plate 253.

According to an embodiment, the first housing 210 may include the first front bracket 215 and a rear bracket 216, and the second housing 220 may include the second front bracket 227. The first front bracket 215 and the rear bracket 216 may be disposed inside the first housing 210 and may support components of the electronic device 200. The second front bracket 227 may be disposed inside the second housing 220 and may support the components of the electronic device 200. For example, the display 230 may be disposed on one surface of the first front bracket 215 and one surface of the second front bracket 227. The rear bracket 216 may be disposed on the other surface of the first front bracket 215 facing the one surface of the first front bracket 215. The sub-display panel 235 may be disposed on the rear bracket 216.

According to an embodiment, a part of the first front bracket 215 may be surrounded by the first side surface 213, and a part of the second front bracket 227 may be surrounded by the second side surface 223. For example, the first front bracket 215 may be integrally formed with the first side surface 213, and the second front bracket 227 may be integrally formed with the second side surface 223. For another example, the first front bracket 215 may be formed separately from the first side surface 213 and the second front bracket 227 may be formed separately from the second side surface 223.

The at least one electronic component 260 may implement various functions for providing to the user. According to an embodiment, the at least one electronic component 260 may include a first printed circuit board 261, a second printed circuit board 262, a flexible printed circuit board 263, a battery 264, and/or an antenna 265. The first printed circuit board 261 and the second printed circuit board 262 may form an electrical connection of the components in the electronic device 200, respectively. For example, components (e.g., the processor 120 of FIG. 1) for implementing overall functions of the electronic device 200 may be disposed on the first printed circuit board 261, and electronic components for implementing some functions of the first printed circuit board 261 may be disposed on the second printed circuit board 262. As another example, components for the operation of the sub-display panel 235 disposed on the fourth surface 222 may be disposed on the second printed circuit board 262.

According to an embodiment, the first printed circuit board 261 may be disposed within the first housing 210. For example, the first printed circuit board 261 may be disposed on the one surface of the first front bracket 215. According to an embodiment, the second printed circuit board 262 may be disposed within the second housing 220. For example, the second printed circuit board 262 may be spaced apart from the first printed circuit board 261 and may be disposed on the one surface of the second front bracket 227. The flexible printed circuit board 263 may connect the first printed circuit board 261 and the second printed circuit board 262. For example, the flexible printed circuit board 263 may extend from the first printed circuit board 261 to the second printed circuit board 262.

The battery 264 is a device for supplying power to at least one component of the electronic device 200, and may include, for example, a non-rechargeable primary battery, a rechargeable secondary battery, or a fuel battery. At least a part of the battery 264 may be disposed on substantially the same plane as the first printed circuit board 261 or the second printed circuit board 262.

The antenna 265 may be configured to receive power or a signal from the outside of the electronic device 200. According to an embodiment, the antenna 265 may be disposed between the rear bracket 216 and the battery 264. The antenna 265 may include, for example, a near field communication (NFC) antenna, a wireless charging antenna, and/or a magnetic secure transmission (MST) antenna. The antenna 265, for example, may perform short-range communication with an external device or may wirelessly transmit/receive power which is required for charging.

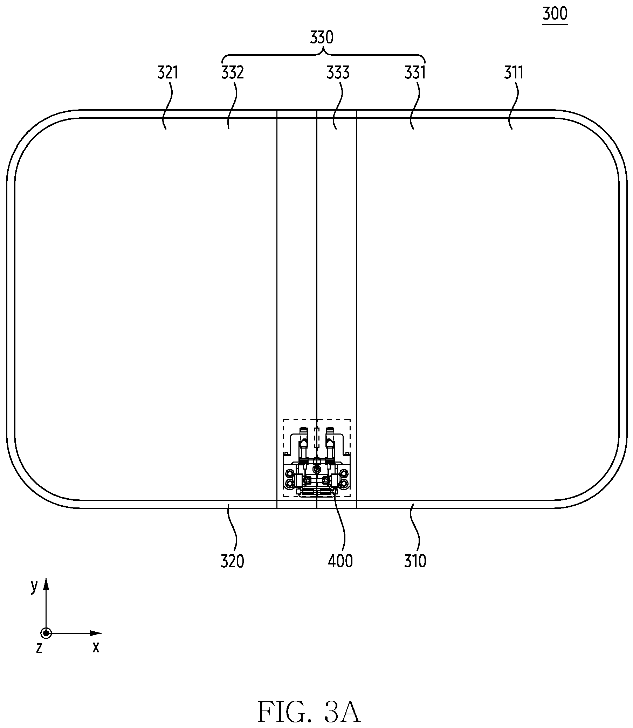

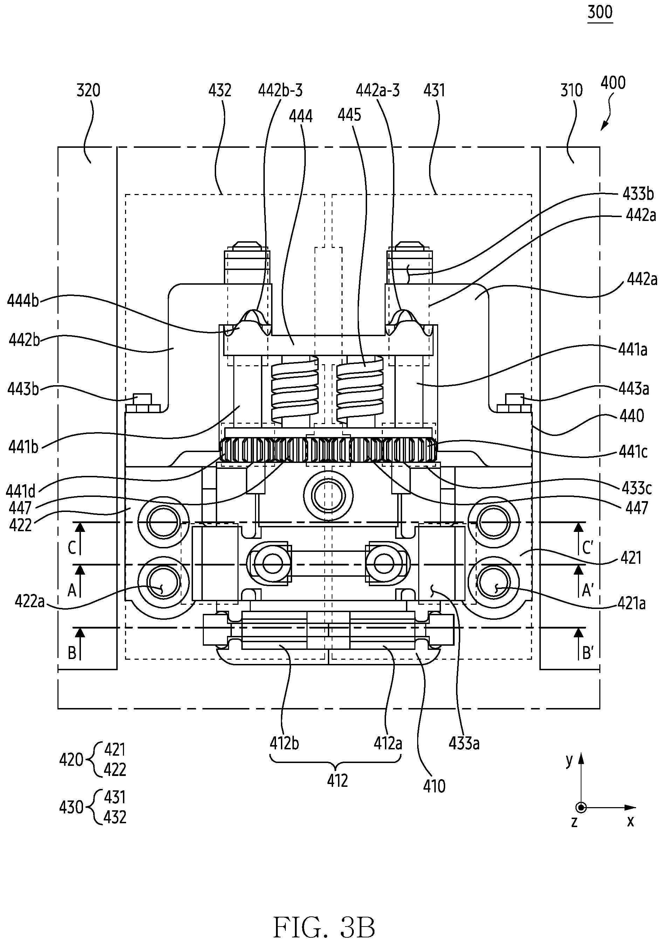

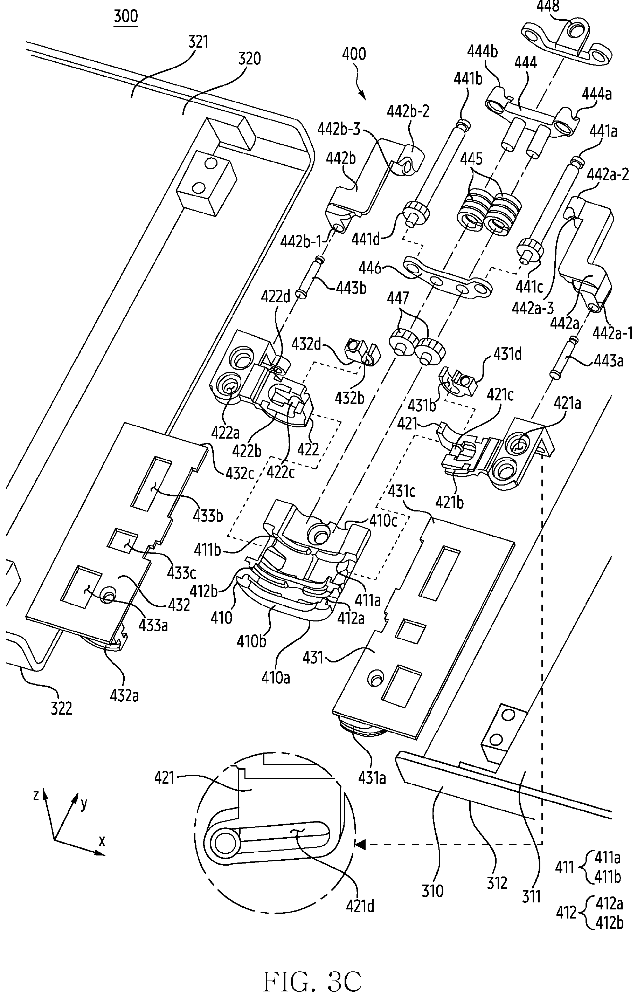

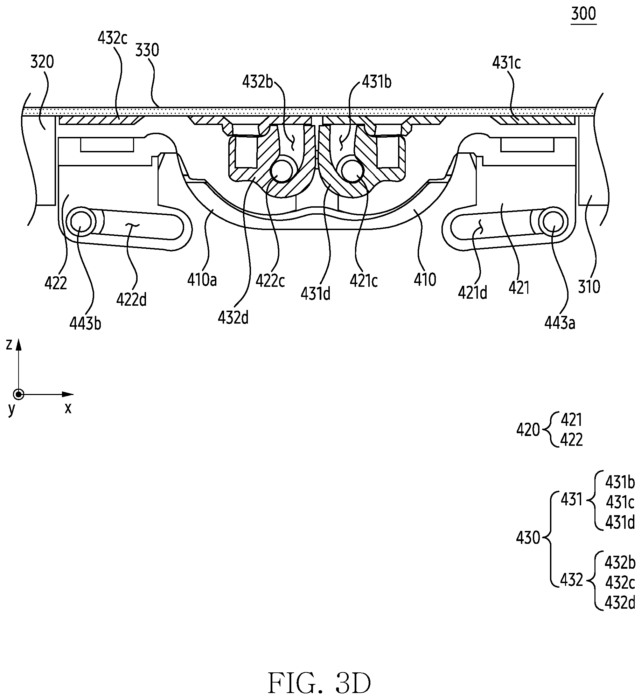

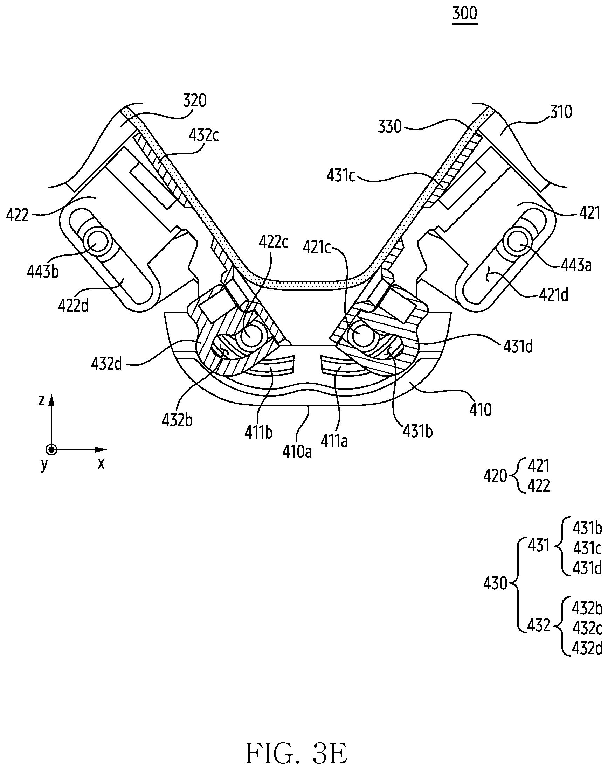

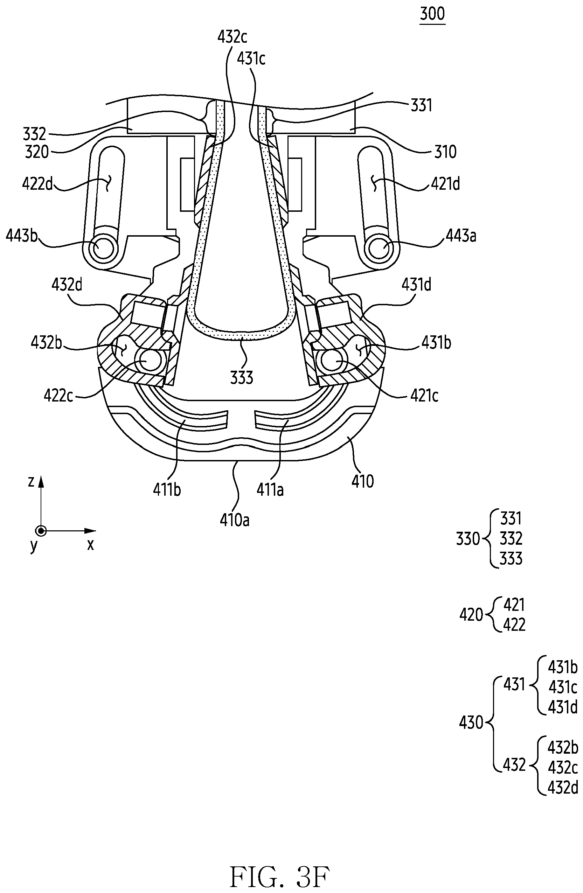

FIG. 3A is a top plan view of an electronic device according to an embodiment, FIG. 3B is an enlarged view enlarging a hinge structure of an electronic device according to an embodiment, FIG. 3C is an exploded perspective view of an electronic device according to an embodiment, FIG. 3D is a cross-sectional view illustrating an example in which a hinge structure of an electronic device according to an embodiment is cut along A-A' of FIG. 3B, FIG. 3E is a cross-sectional view illustrating another example in which a hinge structure of an electronic device according to an embodiment is cut along A-A' of FIG. 3B, and FIG. 3F is a cross-sectional view illustrating the other example in which a hinge structure of an electronic device according to an embodiment is cut along A-A' of FIG. 3B.

Referring to FIGS. 3A, 3B, 3C, 3D, 3E, and 3F, an electronic device 300 includes a first housing 310, a second housing 320, a display 330, and a hinge structure 400. The first housing 310, the second housing 320, and the display 330 of FIGS. 3A, 3B, 3C, 3D, 3E, and 3F may be substantially the same as the first housing 210, the second housing 220, and the display 230 of FIGS. 2A, 2B, and 2C, respectively, and thus an overlapped description thereof will be omitted.

FIG. 3D illustrates an example of a cross-section of the hinge structure 400 when the electronic device 300 is in an unfolded state, FIG. 3E illustrates another example of a cross-section of the hinge structure 400 when the electronic device 300 is in an intermediate state, and FIG. 3F illustrates the other example of a cross-section of the hinge structure 400 when the electronic device 300 is in a folded state.

According to an embodiment, the first housing 310 and the second housing 320 may define at least a part of an outer surface of the electronic device 300. The first housing 310 includes a first surface 311 and a second surface 312 opposite to the first surface 311. For example, the second surface 312 may face the first surface 311 and may be spaced apart from the first surface 311. The second housing 320 includes a third surface 321 and a fourth surface 322 opposite to the third surface 321. For example, the fourth surface 322 may face the third surface 321 and may be spaced apart from the fourth surface 322.

The display 330 is disposed on the first housing 310, the second housing 320, and the hinge structure 400. The display 330 crosses the hinge structure 400, and is disposed on the first surface 311 of the first housing 310 and the third surface 321 of the second housing 320. According to an embodiment, the display 330 may be deformable by a movement of the first housing 310 or the second housing 320. For example, the display 330 may be folded or may be unfolded by the movement of the second housing 320 with respect to the first housing 310. However, it is not limited thereto, and the display 330 may be curved or bent by the movement of the second housing 320 with respect to the first housing 310. According to an embodiment, the display 330 may be referred to as a flexible display. According to an embodiment, the display 330 may include a first display region 331 (e.g., a first display region 231 of FIG. 2A) disposed on the first housing 310, a second display region 332 (e.g., a second display region 232 of FIG. 2A) disposed on the second housing 320 and a third display region 333 (e.g., a third display region 233 of FIG. 2A) disposed on the hinge structure 400. According to various embodiments, the movement of the first housing 310 or the second housing 320 may include rotation of the first housing 310 or the second housing 320.

The hinge structure 400 connects the first housing 310 and the second housing 320 to be movable with respect to each other. By the hinge structure 400, the second housing 320 is rotatable with respect to the first housing 310. For another example, by the hinge structure 400, the second housing 320 may be pivotable with respect to the first housing 310. According to an embodiment, a state of the electronic device 300 may be changed by the movement of the first housing 310 or the second housing 320 through the hinge structure 400. For example, the hinge structure 400 may change the state of the electronic device 300 to the unfolded state in which the directions that the first surface 311 and the third surface 321 of the first housing 310 are facing is the same (or substantially the same) or the folded state in which the first surface 311 and the third surface 321 face each other (e.g., the first surface 311 and the third surface 321 face each other and are parallel). When the electronic device 300 is in the folded state, the direction the first surface 311 is facing and the direction the third surface 321 is facing may be opposite to each other. For another example, the hinge structure 400 may change the state of the electronic device 300 to the intermediate state in which the second housing 320 is inclined with respect to the first housing 310. In the intermediate state of the electronic device 300, the direction the first surface 311 facing and the direction the third surface 321 facing may be inclined with respect to each other. For example, the intermediate state may be referred to as a flex mode.

The hinge structure 400 includes a hinge bracket 410, a rotating member 420 and a supporting member 430. The hinge structure 400 may include a detent structure 440. It will be appreciated that use of the term "rotating member" should not be interpreted to mean that other members, parts. elements etc. cannot rotate. For example, as will be discussed below, the supporting member 430 may be rotatable. In certain embodiments, in a more general sense, the hinge bracket 410, rotating member 420, supporting member 430 and detent structure 440 may be regarded more simply as a first component 410, a second component 420, a third component 430 and a fourth component 440, with the function(s) of these components otherwise being as discussed herein in relation to the hinge bracket 410, rotating member 420, supporting member 430 and detent structure 440.

The hinge bracket 410 may support components of the hinge structure 400. According to an embodiment, the hinge bracket 410 may be disposed between the first housing 310 and the second housing 320. An outer surface 410a of the hinge bracket 410 may face inside of the first housing 310 and the second housing 320. According to an embodiment, the hinge bracket 410 may guide a movement of the rotating member 420 and the supporting member 430. The hinge bracket 410 includes a rotary rail 411 and a guide rail 412. The rotary rail 411 may guide the movement of the rotating member 420. For example, the rotary rail 411 may protrude from an inner surface of the hinge bracket 410 and may have a shape of a protrusion bent to have a curvature, but is not limited thereto. According to an embodiment, the rotary rail 411 may include a first rotary rail 411a facing the first housing 310 and a second rotary rail 411b facing the second housing 320. The second rotary rail 411b may face the first rotary rail 411a and may be spaced apart from the first rotary rail 411a.

According to an embodiment, the guide rail 412 may guide the movement of the supporting member 430. The guide rail 412 may define another rotational axis of the supporting member 430 distinct from the rotational axis of the rotating member 420. For example, the guide rail 412 may protrude from the inner surface of the hinge bracket 410 and may have the shape of the protrusion bent to have the curvature, but is not limited thereto. According to an embodiment, the guide rail 412 may be spaced apart from the rotary rail 411. For example, a first side surface 410b of the hinge bracket 410 may be close to the guide rail 412 among the rotary rail 411 and the guide rail 412. According to an embodiment, the guide rail 412 may include a first guide rail 412a facing the first housing 310 and a second guide rail 412b facing the second housing 320. The second guide rail 412b may face the first guide rail 412a and may be spaced apart from the first guide rail 412a.

The rotating member 420 may rotate together with the first housing 310 and/or the second housing 320 to deform the display 330. According to an embodiment, the rotating member 420 may rotate with respect to the hinge bracket 410 together with the first housing 310 or the second housing 320. The rotating member 420 may fold or unfold the display 330 by rotating with respect to the hinge bracket 410. According to an embodiment, the rotating member 420 may be rotatable along the rotary rail 411 of the hinge bracket 410.

According to an embodiment, the rotating member 420 may include a first rotating member 421 coupled to the first housing 310 and a second rotating member 422 coupled to the second housing 320. The first rotating member 421, as coupled to the first housing 310, may rotate together with the first housing 310 rotating by an external force transmitted from a user. According to an embodiment, the first rotating member 421 may include at least one first coupling hole 421a, a first rotary groove 421b, and a first sliding pin 421c. A coupling member (e.g., a screw) for coupling the first housing 310 and the first rotating member 421 may be inserted into the at least one first coupling hole 421a. According to an embodiment, the first rotary groove 421b may guide a movement of the first rotating member 421 with respect to the hinge bracket 410. The first rotary groove 421b may accommodate the first rotary rail 411a of the hinge bracket 410. As the first rotary rail 411a is inserted into the first rotary groove 421b, the first rotating member 421 may rotate along the first rotary rail 411a by the movement of the first housing 310. The first rotating member 421 may rotate together with the first housing 310 along the first rotary rail 411a by the rotation of the first housing 310. The first sliding pin 421c may rotate together with the first rotating member 421 when the first rotating member 421 rotates. According to an embodiment, the first sliding pin 421c may have a linearly extended shape. For example, the first sliding pin 421c may be integrally formed with the first rotating member 421, but is not limited thereto.

According to an embodiment, the second rotating member 422, as coupled to the second housing 320, may rotate together with the second housing 320 rotated by the user. According to an embodiment, the second rotating member 422 may include at least one second coupling hole 422a and a second rotary groove 422b. A coupling member (e.g., the screw) for coupling the second housing 320 and the second rotating member 422 may be inserted into the at least one second coupling hole 422a. According to an embodiment, the second rotary groove 422b may guide a movement of the second rotating member 422 with respect to the hinge bracket 410. The second rotary groove 422b may accommodate the second rotary rail 411b of the hinge bracket 410. As the second rotary rail 411b is inserted into the second rotary groove 422b, the second rotating member 422 may rotate along the second rotary rail 411b by the movement of the second housing 320. The second rotating member 422 may rotate together with the second housing 320 along the second rotary rail 411b by the rotation of the second housing 320. When the second rotating member 422 rotates, a second sliding pin 422c may rotate together with the second rotating member 422. According to an embodiment, the second sliding pin 422c is included in the second rotating member 422. According to an embodiment, the second sliding pin 422c may have a linearly extended shape. For example, the second sliding pin 422c may be integrally formed with the second rotating member 422, but is not limited thereto.

The supporting member 430 supports one surface of the display 330. The supporting member 430 is rotatable based on another rotational axis distinct from the rotational axis of the rotating member 420 by rotation of the rotating member 420. The supporting member 430 may be rotatable with respect to the hinge bracket 410 by sliding with respect to the rotating member 420. According to an embodiment, the supporting member 430 may include a first supporting member 431 and a second supporting member 432. The first supporting member 431 may be rotatable with respect to the hinge bracket 410 when the first rotating member 421 rotates. For example, the first supporting member 431 may include a first guide groove 431a that guides a movement of the first supporting member 431. The first guide groove 431a may accommodate the first guide rail 412a of the hinge bracket 410. As the first guide rail 412a is inserted into the first guide groove 431a, the first supporting member 431 may be rotatable along the first guide rail 412a. According to an embodiment, the second supporting member 432 may be rotatable with respect to the hinge bracket 410 when the second rotating member 422 rotates. For example, the second supporting member 432 may include a second guide groove 432a that guides a movement of the second supporting member 432. The second guide groove 432a may accommodate the second guide rail 412b of the hinge bracket 410. As the second guide rail 412b is inserted into the second guide groove 432a, the second supporting member 432 may be rotatable along the second guide rail 412b.

According to an embodiment, when the first rotating member 421 rotates, the first supporting member 431 may rotate while sliding with respect to the first rotating member 421. For example, the first supporting member 431 may include a first sliding opening 431b. The first sliding opening 431b may surround the first sliding pin 421c. According to an embodiment, the first sliding opening 431b may have a curvature and may be bent. The first sliding opening 431b may slide with respect to the first sliding pin 421c rotating together with the first rotating member 421. For example, as the first sliding pin 421c is rotated by the first rotating member 421, frictional force may be generated between an outer surface of the first sliding pin 421c and an inner surface of the first sliding opening 431b. The first supporting member 431 may rotate due to the frictional force between the outer surface of the first sliding pin 421c and the inner surface of the first sliding opening 431b.

According to an embodiment, when the second rotating member 422 rotates, the second supporting member 432 may rotate while sliding with respect to the second rotating member 422. For example, the second supporting member 432 may include a second sliding opening 432b. The second sliding opening 432b may surround the second sliding pin 422c. According to an embodiment, the second sliding opening 432b may have a curvature and may be bent. The second sliding opening 432b may slide with respect to the second sliding pin 422c rotating together with the second rotating member 422. For example, as the second sliding pin 422c is rotated by the second rotating member 422, the frictional force may be generated between an outer surface of the second sliding pin 422c and an inner surface of the second sliding opening 432b. The second supporting member 432 may rotate due to the frictional force between the outer surface of the second sliding pin 422c and the inner surface of the second sliding opening 432b.

The detent structure 440 (e.g., a catch structure, or a motion regulation structure) may generate a resistive force that hinders the rotation of the rotating member 420 when the rotating member 420 rotates by the external force. The resistive force generated by the detent structure 440 may be transmitted to the user rotating the first housing 310 and/or the second housing 320. According to an embodiment, the detent structure 440 may prevent a position of the rotating member 420 from being restored to a state before the external force is applied to the rotating member 420 after the external force to rotate the rotating member 420 is removed. According to an embodiment, the detent structure 440 may include a shaft 441, an arm 442, a rotary pin 443, a compressing member 444, at least one elastic member 445, a stopper 446, at least one idle gear 447, and/or a fixing member 448.

When the rotating member 420 rotates, the shaft 441 may receive power (or force) from the rotating member 420 and may be rotatable with respect to the hinge bracket 410. According to an embodiment, the shaft 441 may be disposed outside the hinge bracket 410. For example, the shaft 441 may be disposed on a second side surface 410c opposite to the first side surface 410b of the hinge bracket 410. According to an embodiment, the shaft 441 may include a first shaft 441a receiving power (or force) from the first rotating member 421 and a second shaft 441b receiving power (or force) from the second rotating member 422.

The arm 442 may be rotatable with respect to the shaft 441 and/or the hinge bracket 410 when the rotating member 420 rotates. For example, the arm 442 may include a first arm 442a slidably coupled to the first rotating member 421 and a second arm 442b slidably coupled to the second rotating member 422.

The rotary pin 443 may couple the arm 442 to the rotating member 420 so that the arm 442 may slide with respect to the rotating member 420. According to an embodiment, the rotary pin 443 may include a first rotary pin 443a for coupling the first rotating member 421 and the first arm 442a, and a second rotary pin 443b for coupling the second rotating member 422 and the second arm 442b. For example, the first rotary pin 443a may be coupled to one end 442a-1 of the first arm 442a facing the first rotating member 421. For another example, the second rotary pin 443b may be coupled to one end 442b-1 of the second arm 442b facing the second rotating member 422.

According to an embodiment, the arm 442 may rotate with respect to the shaft 441 while sliding with respect to the rotating member 420. For example, the first rotating member 421 may include a first sliding groove 421d disposed outside the hinge bracket 410. The first sliding groove 421d may be disposed on a part of the first rotating member 421 facing the one end 442a-1 of the first arm 442a. The first sliding groove 421d may have a shape of a linearly extended groove. The first rotary pin 443a may be movable within the first sliding groove 421d. For example, the first rotary pin 443a may penetrate the first sliding groove 421d and the one end 442a-1 of the first arm 442a facing the first sliding groove 421d. The other end 442a-2 of the first arm 442a opposite to the one end 442a-1 of the first arm 442a may be disposed on the first shaft 441a. When the first rotating member 421 rotates, the first rotary pin 443a may slide within the first sliding groove 421d by rotation of the first rotating member 421. The first rotary pin 443a may rotate the first arm 442a with respect to the first shaft 441a as it slides within the first sliding groove 421d.

According to an embodiment, the second rotating member 422 may include a second sliding groove 422d disposed outside the hinge bracket 410. The second sliding groove 422d may have the shape of the linearly extended groove. The second sliding groove 422d may be disposed on a part of the second rotating member 422 facing the one end 442b-1 of the second arm 442b. The second rotary pin 443b may be movable within the second sliding groove 422d. For example, the second rotary pin 443b may penetrate the second sliding groove 422d and the one end 442b-1 of the second arm 442b facing the second sliding groove 422d. The other end 442b-2 of the second arm 442b opposite to the one end 442b-1 of the second arm 442b may be disposed on the first shaft 441a. When the second rotating member 422 rotates, the second rotary pin 443b may slide within the second sliding groove 422d by rotation of the second rotating member 422. The second rotary pin 443b may rotate the second arm 442b with respect to the second shaft 441b as it slides within the second sliding groove 422d.

According to an embodiment, the compressing member 444 may be coupled to the shaft 441 so as to be movable linearly with respect to the shaft 441. The compressing member 444 may include a first delivering cam 444a and a second delivering cam 444b disposed on a part of the compressing member 444 facing the arm 442. The first delivering cam 444a may face the other end 441a-2 of the first arm 442a. The second delivering cam 444b may face the other end 442b-2 of the second arm 442b. According to an embodiment, the first arm 442a may include a first driving cam 442a-3 disposed on the other end 442a-2 of the first arm 442a. The first driving cam 442a-3 and the first delivering cam 444a may have shapes corresponding to each other and may be in contact with each other. According to an embodiment, the second arm 442b may include a second driving cam 442b-3 disposed on the other end 442b-2 of the second arm 442b. The second driving cam 442b-3 and the second delivering cam 444b may have shapes corresponding to each other and may be in contact with each other.

The at least one elastic member 445 (e.g., at least one resiliently deformable member) may be deformed by a relative movement of the compressing member 444 with respect to the shaft 441. According to an embodiment, the at least one elastic member 445 may be disposed between the compressing member 444 and the hinge bracket 410. For example, one end of the at least one elastic member 445 may be in contact with the compressing member 444, and the other end of the at least one elastic member 445 opposite to the one end of the at least one elastic member 445 may be in contact with the stopper 446. For example, the at least one elastic member 445 may be a spring, but is not limited thereto.

The stopper 446 may be coupled to the shaft 441. For example, the shaft 441 may penetrate the stopper 446. The stopper 446 may be fixed to the shaft 441 and may not move. According to an embodiment, the stopper 446 may be disposed outside the hinge bracket 410 and may face the second side surface 410c of the hinge bracket 410.

The at least one idle gear 447 may be disposed outside the hinge bracket 410. The at least one idle gear 447 may face the second side surface 410c of the hinge bracket 410 and may be rotatable with respect to the hinge bracket 410. According to an embodiment, the at least one idle gear 447 may be disposed between the stopper 446 and the hinge bracket 410. According to an embodiment, the at least one idle gear 447 may be engaged with shaft gears 441c and 441d disposed on at least one of the first shaft 441a and the second shaft 441b. For example, the first shaft 441a may include a first shaft gear 441c rotatable by rotation of the first shaft 441a. For another example, the second shaft 441b may include a second shaft gear 441d rotatable by rotation of the second shaft 441b. The at least one idle gear 447 may be disposed between the first shaft gear 441c and the second shaft gear 441d and may be engaged with the first shaft gear 441c and the second shaft gear 441d.

The fixing member 448 may prevent separation of the components of the hinge structure 400. According to an embodiment, the fixing member 448 may be coupled to the shaft 441. For example, the fixing member 448 may face the other region of the compressing member 444 opposite to one region of the compressing member 444 facing the at least one elastic member 445.

According to an embodiment, the rotary pin 443 may rotate the arm 442 with respect to the shaft 441 by the rotation of the rotating member 420. The arm 442 may be rotated by sliding of the rotary pin 443 with respect to the rotating member 420 to move the compressing member 444. The arm 442 may press (e.g., apply force to, or increase an amount of force applied to) the at least one elastic member 445 by moving the compressing member 444 in a direction close to the hinge bracket 410 (e.g., -y direction) or depress or relieve (e.g., remove a force applied to, or decrease an amount of force applied to) the at least one elastic member 445 by allowing the compressing member 444 to move in a direction away from the hinge bracket 410 (e.g., +y direction). For example, when the first rotating member 421 rotates, the first arm 442a may rotate by sliding of the first rotary pin 443a. As the first arm 442a rotates, the first driving cam 442a-3 disposed on the other end 442a-2 of the first arm 442a may rotate. As the first driving cam 442a-3 rotates, the first delivering cam 444a in contact with the first driving cam 442a-3 may move the compressing member 444. The at least one elastic member 445 may be compressed or extended by the compressing member 444 moving in the direction close to the hinge bracket 410 or in the direction away from the hinge bracket 410. The frictional force may be generated between the first driving cam 442a-3 and the first delivering cam 444a by compression or extension of the at least one elastic member 445. The frictional force generated between the first driving cam 442a-3 and the first delivering cam 444a may act as the resistive force that hinders rotation of the first arm 442a and the rotation of the first rotating member 421.

According to an embodiment, the supporting member 430 may include a plurality of operating openings 433 penetrating the supporting member 430. The plurality of operating openings 433 may prevent interference of components within the hinge structure 400. For example, the plurality of operating openings 433 may include a plurality of first operating openings 433a overlapping each of the first rotating member 421 and the second rotating member 422 when the hinge structure 400 is viewed from above (e.g., -z direction). For another example, the plurality of operating openings 433 may include a plurality of second operating openings 433b overlapping each of the other end 442a-2 of the first arm 442a and the other end 442b-2 of the second arm 442b when the hinge structure 400 is viewed from above (e.g., the -z direction). For still another example, the plurality of operating openings 433 may include a plurality of third operating openings 433c overlapping the first shaft gear 441c and the second shaft gear 441d, respectively, when the hinge structure 400 is viewed from above (e.g., the -z direction).

Referring again to FIGS. 3D, 3E, and 3F, according to an embodiment, when the electronic device 300 is in the unfolded state, one surface of the first supporting member 431 and one surface of the second supporting member 432 facing the one surface of the display 330 may be parallel to each other. When the external force received from (i.e., applied by) the user is transmitted through the first housing 310, the first rotating member 421 connected to the first housing 310 may rotate with respect to the hinge bracket 410 together with the first housing 310. By the rotation of the first rotating member 421, the first display region 331 of the display 330 disposed on the first housing 310 may move. By the rotation of the first rotating member 421, the first sliding pin 421c may rotate with respect to the hinge bracket 410. The first sliding opening 431b in contact with the outer surface of the first sliding pin 421c may slide with respect to the first sliding pin 421c. By a movement of the first sliding pin 421c, the first supporting member 431 may rotate with respect to the hinge bracket 410. A part of the third display region 333 of the display 330 may move by rotation of the first supporting member 431.

According to an embodiment, when the external force received from (i.e., applied by) the user is transmitted through the second housing 320, the second rotating member 422 connected to the second housing 320 may rotate with respect to the hinge bracket 410 together with the second housing 320. By the rotation of the second rotating member 422, the second display region 332 of the display 330 disposed on the second housing 320 may move. By the rotation of the second rotating member 422, the second sliding pin 422c may rotate with respect to the hinge bracket 410. The second sliding opening 432b in contact with the outer surface of the second sliding pin 422c may slide with respect to the second sliding pin 422c. By a movement of the second sliding pin 422c, the second supporting member 432 may rotate with respect to the hinge bracket 410. Another part of the third display region 333 of the display 330 may move by rotation of the second supporting member 432. According to an embodiment, when the electronic device 300 is in the folded state, the part of the third display region 333 facing the hinge bracket 410 may have a curvature and may be bent.

According to an embodiment, the rotating member 420 may rotate with respect to the hinge bracket 410 within a first angle range, and the supporting member 430 may rotate with respect to the hinge bracket 410 within a second angle range bigger than the first angle range. For example, the difference between the first angle range and the second angle range may result from the rotating member 420 being rotatable based on a rotational axis different to another rotational axis based on which the supporting member 430 is rotatable; in other words, the difference between the first angle range and the second angle range may result from the difference between the rotational axis of the rotating member 420 and the rotational axis of the supporting member 430. For example, the first angle range may be 0 degrees to 90 degrees, and the second angle range may be 0 degrees to 100 degrees. For another example, while the state of the electronic device 300 is changed from the unfolded state to the folded state, rotation angles of the first rotating member 421 and the second rotating member 422 may be 90 degrees, respectively, and rotation angles of the first supporting member 431 and the second supporting member 432 may be 100 degrees, respectively.

According to an embodiment, when the electronic device 300 is in the folded state, the one surface of the first supporting member 431 and the one surface of the second supporting member 432 facing the display 330 may be inclined with respect to each other. When the electronic device 300 is in the folded state, the part of the third display region 333 supported by the supporting member 430 may be inclined with respect to at least one of the first display region 331 and the second display region 332. For example, the part of the third display region 333 supported by the first supporting member 431 may be inclined with respect to the first display region 331 disposed in the first housing 310. An angle between the part of the third display region 333 supported by the first supporting member 431 and the first display region 331 may be an obtuse angle. For another example, another part of the third display region 333 supported by the second supporting member 432 may be inclined with respect to the second display region 332 disposed in the second housing 320. An angle between another part of the third display region 333 supported by the second supporting member 432 and the second display region 332 may be the obtuse angle.

The electronic device 300 according to an embodiment may provide a structure capable of reducing damage to the display 330 by the supporting member 430 having a rotation angle range different from that of the rotating member 420. For example, in case that the rotation angle ranges of the rotating member 420 and the supporting member 430 are the same, within the folded state of the electronic device 300, the one surface of the first supporting member 431 and the one surface of the second supporting member 432 facing the third display region 333 may be parallel to each other. In case that the one surface of the first supporting member 431 and the one surface of the second supporting member 432 are parallel to each other, a curvature of the part of the third display region 333 facing the hinge bracket 410 within the folded state of the electronic device 300 may be rapidly changed between the first supporting member 431 and the second supporting member 432. When the curvature of the part of the third display region 333 changes rapidly between the first supporting member 431 and the second supporting member 432, as folding of the display 330 is repeated, a wrinkle may be formed in the part of the third display region 333. The electronic device 300 according to an embodiment may provide a structure in which the change of the curvature of the part of the third display region 333 is gentle between the first supporting member 431 and the second supporting member 432 by the supporting member 430 with the rotation angle range different from that of the rotating member 420. For example, the bend in the part of the third display region 333 facing the hinge bracket is sharper (i.e., tighter) in the case of the one surface of the first supporting member 431 and the one surface of the second supporting member 432 are parallel to each other, compared to the case of an embodiment of the present disclosure due to the supporting member 430 having a rotation angle range different to that of the rotating member 420. The electronic device 300 according to an embodiment may provide a structure that reduces forming of a wrinkle on the display 330 since the curvature of the part of the third display region 333 is gently changed.

According to an embodiment, when the hinge structure 400 is viewed from above, the first sliding pin 421c and the second sliding pin 422c may overlap the hinge bracket 410. For example, the first sliding pin 421c may be disposed inside the hinge bracket 410 when the hinge structure 400 is viewed from above. For another example, the second sliding pin 422c may be disposed the inside the hinge bracket 410 when the hinge structure 400 is viewed from above. For example, in case that the first sliding pin 421c that transmits driving force of the first rotating member 421 to the first supporting member 431 is disposed outside the hinge bracket 410, a size of the hinge structure 400 may increase. When the hinge structure 400 become bigger, a space for disposing components within the first housing 310 or the second housing 320 may be reduced. The electronic device 300 according to an embodiment may provide a structure capable of securing the space for disposing components within the first housing 310 or the second housing 320 by sliding pins 421c and 422c overlapping the hinge bracket 410 while transmitting the driving force of the rotating member 420 to the supporting member 430.

Referring again to FIG. 3C, according to an embodiment, the first supporting member 431 may include a first supporting plate 431c and a first connecting member 431d. The first supporting plate 431c may support the one surface of the display 330. The first guide groove 431a may be disposed on the first supporting plate 431c. The first supporting plate 431c may be rotatable with respect to the hinge bracket 410. The first connecting member 431d may be coupled to the first supporting plate 431c to move together with the first supporting plate 431c. The first sliding opening 431b may be disposed on the first connecting member 431d. One end of the first sliding opening 431b disposed on the first connecting member 431d may be opened. When manufacturing the hinge structure 400, the first supporting plate 431c and the first connecting member 431d may be separately manufactured. When manufacturing the hinge structure 400, through one end of the opened first sliding opening 431b, the first sliding pin 421c may be inserted into the first sliding opening 431b. After the first sliding pin 421c is inserted into the first sliding opening 431b, the first supporting plate 431c may cover the one end of the opened first sliding opening 431b. After the first supporting plate 431c is disposed on the first connecting member 431d, the first supporting plate 431c and the first connecting member 431d may be coupled to each other through a coupling member (e.g., a/the screw) penetrating the first supporting plate 431c and the first connecting member 431d. The first supporting plate 431c and the first connecting member 431d may be coupled to each other to form the first supporting member 431.

According to an embodiment, the second supporting member 432 may include a second supporting plate 432c and a second connecting member 432d. The second supporting plate 432c may support the one surface of the display 330. The second guide groove 432a may be disposed on the second supporting plate 432c. The second supporting plate 432c may be rotatable with respect to the hinge bracket 410. The second connecting member 432d may be coupled to the second supporting plate 432c to move together with the second supporting plate 432c. The second sliding opening 432b may be disposed on the second connecting member 432d. One end of the second sliding opening 432b disposed on the second connecting member 432d may be opened. When manufacturing the hinge structure 400, the second supporting plate 432c and the second connecting member 432d may be separately manufactured. When manufacturing the hinge structure 400, through one end of the opened second sliding opening 432b, the second sliding pin 422c may be inserted into the second sliding opening 432b. After the second sliding pin 422c is inserted into the second sliding opening 432b, the second supporting plate 432c may cover the one end of the opened second sliding opening 432b. After the second supporting plate 432c is disposed on the second connecting member 432d, the second supporting plate 432c and the second connecting member 432d may be coupled to each other through a coupling member (e.g., a/the screw) penetrating the second supporting plate 432c and the second connecting member 432d. The second supporting plate 432c and the second connecting member 432d may be coupled to each other to form the second supporting member 432.

As described above, the electronic device 300 according to an embodiment may provide a structure capable of reducing formation of a wrinkle of the display 330 by the rotating member 420 and the supporting member 430 rotatable in different angle ranges each other. The electronic device 300 according to an embodiment may provide a structure capable of miniaturizing, or otherwise reducing the size of, the hinge structure 400 by the sliding pins 421c and 422c that transmit the driving force of the rotating member 420 to the supporting member 430, e.g., by disposing the sliding pins 421c and 422c to overlap the hinge bracket 410 when viewed from above (that is, disposing the sliding pins 421c and 422c inside the hinge bracket 410 when the hinge structure 400 is viewed from above).

Meanwhile, the electronic device 300 is illustrated as including one hinge structure 400 in FIGS. 3A, 3B, 3C, 3D, 3E, and 3F, but this is for convenience of description. According to embodiments, the electronic device 300 may include a plurality of hinge structures 400. For example, a plurality of hinge structures 400 may be disposed between the first housing 310 and the second housing 320.

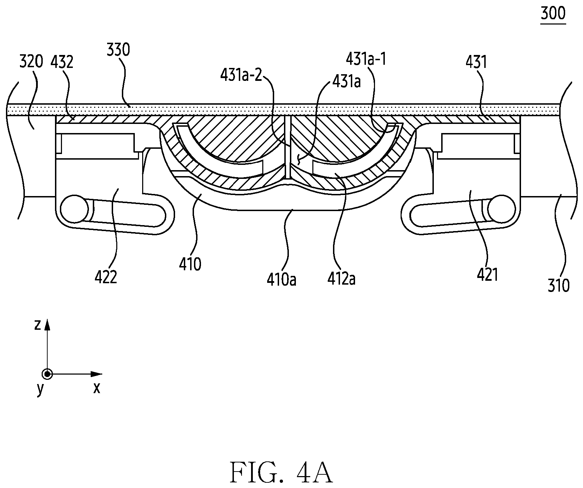

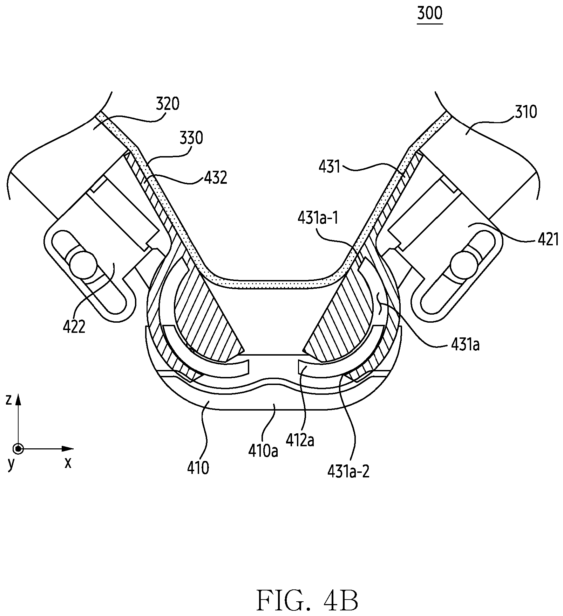

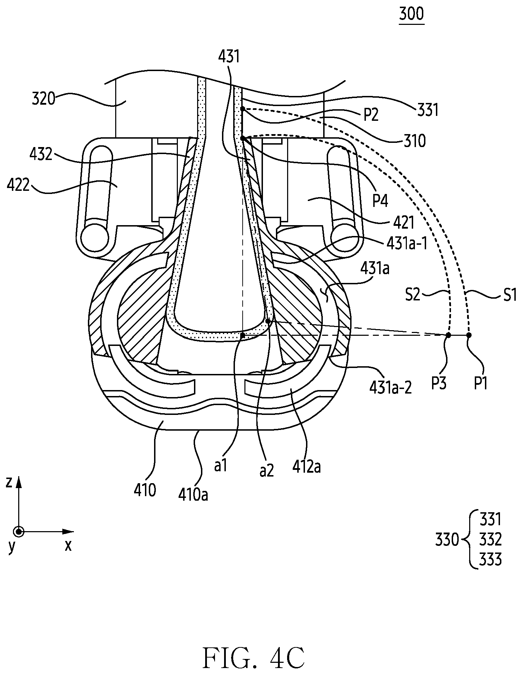

FIG. 4A is a cross-sectional view illustrating an example in which a hinge structure of an electronic device according to an embodiment is cut along B-B' of FIG. 3B, FIG. 4B is a cross-sectional view illustrating another example in which a hinge structure of an electronic device according to an embodiment is cut along B-B' of FIG. 3B, and FIG. 4C is a cross-sectional view illustrating the other example in which a hinge structure of an electronic device according to an embodiment is cut along B-B' of FIG. 3B.

FIG. 4A illustrates an example of a cross-section of the hinge structure (e.g., a hinge structure 400 of FIGS. 3A, 3B, and 3C) when an electronic device 300 is in an unfolded state (e.g., a fully unfolded state), FIG. 4B illustrates another example of a cross-section of the hinge structure 400 when the electronic device 300 is in an intermediate state (e.g., a partially folded/partially unfolded state), and FIG. 4C illustrates the other example of a cross-section of the hinge structure 400 when the electronic device 300 is in a folded state (e.g., a fully folded state).

Description of operation of the hinge structure 400 of FIGS. 4A, 4B, and 4C, which will be described later, is described based on a first housing 310, a first rotating member 421, and a first supporting member 431, but this is for convenience of description. Description of operation of the first housing 310, the first rotating member 421, and the first supporting member 431 may be applied substantially the same to a second housing 320, a second rotating member 422, and a second supporting member 432.

Referring to FIGS. 4A, 4B, and 4C, according to an embodiment, the first rotating member 421 may be rotatable with respect to a hinge bracket 410 based on a first rotational axis a1 (e.g., the first rotating member 421 may rotate about the first rotational axis a1). For example, the first rotating member 421 may be coupled to the first housing 310 and may be rotatable based on the first rotational axis a1 fixed together with the first housing 310. The first housing 310 may share the first rotational axis a1 with the first rotating member 421, and may be rotatable based on the first rotational axis a1. A position of the first rotational axis a1 may be defined outside a hinge bracket 410. According to an embodiment, the first rotational axis a1 may be fixed while the first rotating member 421 rotates. For example, while a state of the electronic device 300 is changed from the unfolded state to the folded state, the position of the first rotational axis a1 may be fixed.

According to an embodiment, the first supporting member 431 may be rotatable with respect to the hinge bracket 410 based on a second rotational axis a2 distinct from the first rotational axis a1 (e.g., the first supporting member 431 may rotate about the second rotational axis a2). According to an embodiment, a position of the second rotational axis a2 may be defined outside the hinge bracket 410. The position of the second rotational axis a2 may be different from the position of the first rotational axis a1. For example, a distance between the second rotational axis a2 and the hinge bracket 410 may be bigger than a distance between the first rotational axis a1 and the hinge bracket 410. As the position of the second rotational axis a2 and the position of the first rotational axis a1 are different, while the state of the electronic device 300 is changed from the unfolded state to the folded state, rotation angles of the first rotating member 421 and the first supporting member 431 may be different from each other.

According to an embodiment, while the state of the electronic device 300 is changed from the unfolded state to the folded state, a first guide groove 431a of the first supporting member 431 may rotate along a first guide rail 412a of the hinge bracket 410. For example, one end 431a-1 of the first guide groove 431a of the first supporting member 431 facing a display 330 may be in contact with the first guide rail 412a when the electronic device 300 is in the unfolded state. While the electronic device 300 is changed from the unfolded state to the folded state, the one end 431a-1 of the first guide groove 431a may move in a direction away from the first guide rail 412a by rotation of the first supporting member 431. For example, as the first supporting member 431 rotates with respect to the hinge bracket 410, the first guide groove 431a is moved around the first guide rail 412a such that the first guide rail 412a is exposed from the first guide groove 431a.

According to an embodiment, the first guide rail 412a may have a constant width and may extend. For example, the first guide rail 412a may have a constant curvature and may extend. According to an embodiment, a size of the first guide groove 431a of the first supporting member 431 may not be constant along a guide rail 412. For example (as illustrated in FIGS. 4A to 4C), a width of the one end 431a-1 of the first guide groove 431a of the first supporting member 431 facing the display 330 (or closer to the display 330) may be smaller than a width of the other end 431a-2 of the first guide groove 431a. For another example, the width of the one end 431a-1 of the first guide groove 431a may correspond to a width of the first guide rail 412a, and the width of the other end 431a-2 of the first guide groove 431a may be bigger than the width of the first guide rail 412a. For still another example, a width of the first guide groove 431a may increase from the one end 431a-1 of the first guide groove 431a toward the other end 431a-2 of the first guide groove 431a.

According to an embodiment, as the state of the electronic device 300 is changed from the folded state to the unfolded state, the first supporting member 431, or at least a part thereof, may move in a direction (e.g., -z direction) toward an outer surface 410a of the hinge bracket 410 while rotating. For example, the first supporting member 431 may move in the direction (e.g., the -z direction) toward the outer surface 410a of the hinge bracket 410 when an angle between the first housing 310 and the second housing 320 is greater than or equal to a designated angle or within a designated angle range. The designated angle or designated range may refer to when the angle between the first housing 310 and the second housing 320 is 90 degrees to 180 degrees. A case that the angle between the first housing 310 and the second housing 320 is 90 degrees to 180 degrees may mean a case that each of the first supporting member 431 and the first housing 310 rotates by approximately 0 degrees to 45 degrees from the unfolded state of the electronic device 300.

As the first supporting member 431 rotates and moves in a direction toward the outer surface 410a of the hinge bracket 410, the second rotational axis a2 of the first supporting member 431 may be changed while the first supporting member 431 rotates. In case that both the position of the first rotational axis a1 of the first housing 310 and the position of the second rotational axis a2 of the first supporting member 431 are fixed, as the state of the electronic device 300 is changed, compression of the display 330 may occur at a boundary between the first housing 310 and the first supporting member 431. For example, referring to FIG. 4C, while the state of the electronic device 300 is changed from the unfolded state to the folded state, the first housing 310 may rotate 90 degrees together with the first rotating member 421. In case that the first rotational axis a1 is fixed, while the state of the electronic device 300 is changed from the unfolded state to the folded state, a first point of the first housing 310 may move along a first trajectory S1 from a first position P1 toward a second position P2. While the state of the electronic device 300 is changed from the unfolded state to the folded state, the first supporting member 431 may rotate 100 degrees with respect to the hinge bracket 410. In case that the second rotational axis a2 is fixed, while the state of the electronic device 300 is changed from the unfolded state to the folded state, a second point of the first supporting member 431 may move along a second trajectory S2 from a third position P3 toward a fourth position P4. As the position of the first rotational axis a1 and the position of the second rotational axis a2 are different, a distance between the first trajectory S1 and the second trajectory S2 may be changed. For example, from the unfolded state of the electronic device 300, as each of the first housing 310 and the first supporting member 431 rotates by 0 degrees to 45 degrees, the distance between the first trajectory S1 and the second trajectory S2 may be reduced. For example, from the unfolded state of the electronic device 300, as each of the first housing 310 and the first supporting member 431 rotates by approximately 0 degrees to 45 degrees, the distance between the first trajectory S1 and the second trajectory S2 may be reduced. For another example, from the unfolded state of the electronic device 300, as each of the first housing 310 and the first supporting member 431 rotates by approximately 45 degrees to 90 degrees, the distance between the first trajectory S1 and the second trajectory S2 may increase. The decrease in the distance between the first trajectory S1 and the second trajectory S2 may mean that compressive stress is generated at the boundary between the first supporting member 431 and the first housing 310 while the state of the electronic device 300 is changed from the unfolded state to the folded state. The compressive stress generated at the boundary between the first supporting member 431 and the first housing 310 may be transmitted to the display 330 disposed on the boundary between the first housing 310 and the first supporting member 431. The electronic device 300 according to an embodiment may provide a structure capable of preventing the compression of the display 330 at the boundary between the first housing 310 and the first supporting member 431 by the first supporting member 431 including the first guide groove 431a whose width is changed. For example, since the width of the other end 431a-2 of the first guide groove 431a is bigger than the width of the first guide rail 412a, the first supporting member 431 may move in the direction toward the outer surface 410a of the hinge bracket 410 by the display 330 while rotating. As the first supporting member 431 moves in the direction toward the outer surface 410a of the hinge bracket 410, since the position of the second rotational axis a2 is changed, the decrease in a distance between the first supporting member 431 and the first housing 310 may be prevented. As the decrease in the distance between the first supporting member 431 and the first housing 310 is prevented while the first supporting member 431 rotates, the electronic device 300 according to an embodiment may provide a structure capable of reducing the compression of the display 330.

As described above, the electronic device 300 according to an embodiment may provide a structure capable of reducing damage to the display 330 by the first supporting member 431 rotating with respect to the variable second rotational axis a2 while the state of the electronic device 300 is changed from the unfolded state to the folded state.

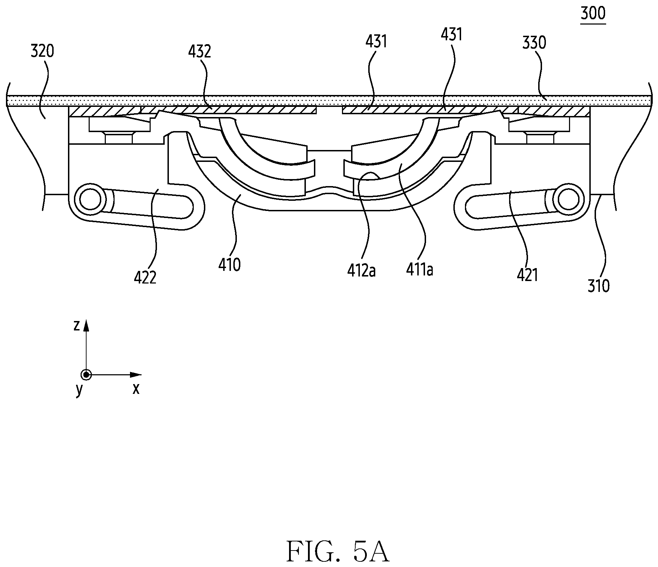

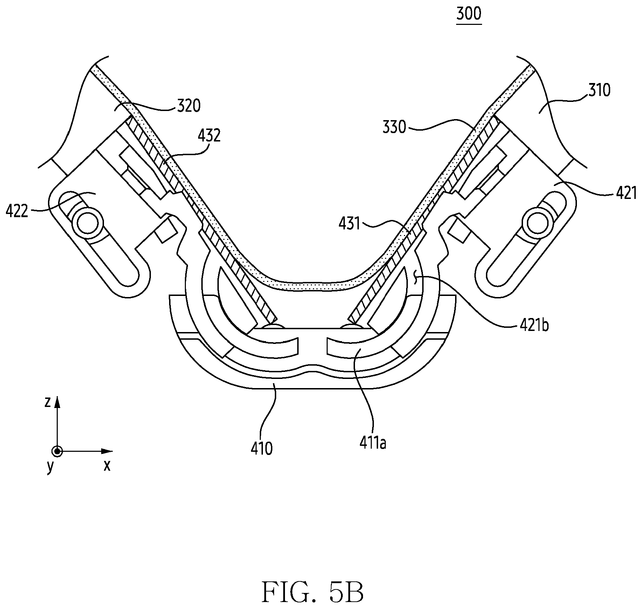

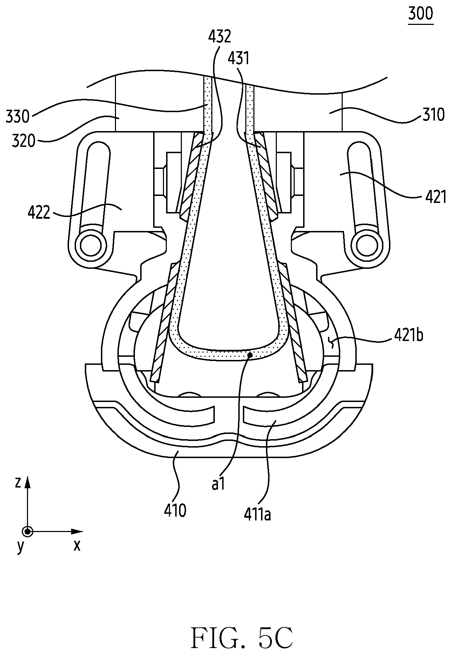

FIG. 5A is a cross-sectional view illustrating an example in which a hinge structure of an electronic device according to an embodiment is cut along C-C' of FIG. 3B, FIG. 5B is a cross-sectional view illustrating another example in which a hinge structure of an electronic device according to an embodiment is cut along C-C' of FIG. 3B, and FIG. 5C is a cross-sectional view illustrating the other example in which a hinge structure of an electronic device according to an embodiment is cut along C-C' of FIG. 3B.

FIG. 5A illustrates an example of a cross-section of the hinge structure (e.g., a hinge structure 400 of FIGS. 3A, 3B, and 3C) when an electronic device 300 is in an unfolded state (e.g., a fully unfolded state), FIG. 5B illustrates another example of a cross-section of the hinge structure 400 when the electronic device 300 is in an intermediate state (e.g., a partially folded/partially unfolded state), and FIG. 5C illustrates the other example of a cross-section of the hinge structure 400 when the electronic device 300 is in a folded state (e.g., a fully folded state).

Description of operation of the hinge structure 400 of FIGS. 5A, 5B, and 5C, which will be described later, is described based on a first housing 310, a first rotating member 421, and a first supporting member 431, but this is for convenience of description. Description of operation of the first housing 310, the first rotating member 421, and the first supporting member 431 may be applied substantially the same to a second housing 320, a second rotating member 422, and a second supporting member 432.

Referring to FIGS. 5A, 5B, and 5C, according to an embodiment, a first rotary rail 411a may have a constant width and may extend. For example, the first rotary rail 411a may have a constant curvature and may extend. According to an embodiment, a first rotary groove 421b of the first rotating member 421, along the first rotary rail 411a, may have the constant curvature and may extend. For example, the first rotary groove 421b may have a width corresponding to a width of the first rotary rail 411a. A width of the first rotary groove 421b may be constant along the first rotary rail 411a. As the widths of the first rotary rail 411a and the first rotary groove 421b are constant, the first rotating member 421 and the first housing 310 may be rotatable based on a fixed first rotational axis a1. While a state of the electronic device 300 is changed from the unfolded state to the folded state, most of driving force for folding the display 330 may be transmitted from the first housing 310 and/or the second housing 320. Ratio of the driving force that the first housing 310 contributes to the folding of the display 330 may be bigger than ratio of the driving force that the first supporting member 431 contributes to the folding of the display 330. In order to prevent the compression of the display 330, in case that a second rotational axis a2 of the first supporting member 431 is fixed and the first rotational axis a1 of the first housing 310 moves, rotation of the first housing 310 for transmitting the driving force for folding the display 330 may become unstable. The electronic device 300 according to an embodiment may provide a structure in which the first housing 310 may stably rotate since the first rotational axis a1 of the first housing 310 that transmits most of the driving force for folding the display 330 is fixed.

As described above, the electronic device 300 according to an embodiment may provide a structure capable of stably changing the state of the electronic device 300 since the first rotational axis a1 of the first housing 310 that transmits most of the driving force for folding the display 330 is fixed.

There now follows a description of a number of paragraphs describing various embodiments of the disclosure. It will be appreciated that the disclosure includes each of these embodiments in isolation, and, even when there is no direct reference between embodiments, also each and every combination of the embodiments (i.e., each and every embodiment formed by combining any two or more of the paragraphs).

According to an embodiment, an electronic device (e.g., an electronic device 300 of FIG. 3A) may comprise a first housing (e.g., a first housing 310 of FIG. 3A) including a first surface (e.g., a first surface 311 of FIG. 3A) and a second surface (e.g., a second surface 312 of FIG. 3A) opposite to the first surface; a second housing (e.g., a second housing 320 of FIG. 3A) including a third surface (e.g., a third surface 321 of FIG. 3A) and a fourth surface (e.g., a fourth surface 322 of FIG. 3A) opposite to the third surface; a hinge structure (e.g., a hinge structure 400 of FIGS. 3A, 3B, 3C, 3D, 3E, and 3F) changeable to a folded state in which the first surface faces the third surface, or an unfolded state in which a direction the first surface facing is the same as a direction the third surface facing, by pivotably connecting the first housing and the second housing; and a display (e.g., a display 330 of FIG. 3A) disposed on the first surface and the third surface across the hinge structure. According to an embodiment, the hinge structure may include a hinge bracket (e.g., a hinge bracket 410 of FIG. 3C) including a rotary rail (e.g., a first rotary rail 411a of FIG. 3C) and a guide rail (e.g., a first guide rail 412a of FIG. 3C) distinct from the rotary rail. According to an embodiment, the hinge structure may include a sliding pin (e.g., a first sliding pin 421c of FIG. 3C, FIG. 3D, FIG. 3E, and FIG. 3F) disposed inside the hinge bracket, may be coupled to the first housing, and may include a rotating member (e.g., a first rotating member 421 of FIGS. 3C, 3D, 3E and 3F) rotatable based on a first rotational axis (e.g., a first rotational axis 421 of FIFS. 4A, 4B, and 4C) along the rotary rail by the movement of the first housing. According to an embodiment, the hinge structure may include a sliding opening (e.g., a first sliding opening 431b of FIGS. 3C, 3D, 3E, and 3F) slidable with respect to the sliding pin, and a guide groove (e.g., a first guide groove 431a of FIGS. 3C, 3D, 3E, and 3F) guided by the guide rail, and may include a supporting member (e.g., a first supporting member 431 of FIGS. 3C, 3D, 3E, and 3F) supporting one surface of the display. According to an embodiment, the supporting member may be rotatable based on a second rotational axis (e.g., a second rotational axis a2 of FIGS. 4A, 4B, and 4C) distinct from the first rotational axis along the guide rail by sliding of the sliding opening. According to an embodiment, a width of one end (e.g., the other end 431a-2 of FIGS. 4A, 4B, and 4C) of the guide groove may be bigger than a width of the other end of the guide groove facing the one surface of the display (e.g., one end 431a-1 of FIGS. 4A, 4B, and 4C).

According to an embodiment, the supporting member may move in a direction toward an outer surface (e.g., an outer surface 410a of FIG. 3C) of the hinge bracket while a state of the electronic device is changed from the unfolded state to an intermediate state of the electronic device inclined with respect to each other of the first housing and the second housing.

According to an embodiment, the first rotational axis may be a fixing axis fixed while the rotating member rotates. The second rotational axis may be a movement axis that changes according to the movement of the supporting member.

According to an embodiment, a width of the guide groove may increase from one end of the guide groove toward the other end of the guide groove.

According to an embodiment, the sliding opening may be bent to have a curvature.

According to an embodiment, the sliding pin may be disposed inside the hinge bracket.

According to an embodiment, when the electronic device is in an unfolded state, one surface of the supporting member facing the display may be parallel to one surface of the rotating member, and when the electronic device is in a folded state, the one surface of the supporting member may be inclined with respect to the one surface of the rotating member.

According to an embodiment, the rotating member may further include a rotary groove (e.g., a first rotary groove 421b of FIG. 3C) having a constant curvature along the rotary rail and guided by the rotary rail.

According to an embodiment, the supporting member may include a supporting plate (e.g., a first supporting plate 431c of FIG. 3C) in which the guide groove disposed and supporting the one surface of the display. According to an embodiment, the supporting member may further include a connecting member (e.g., a first connecting member 431d of FIG. 3C) in which the sliding opening disposed and coupled to the supporting plate to move together with the supporting plate.

According to an embodiment, one end of the sliding opening disposed in the connecting member may be opened toward to the supporting plate.

According to an embodiment, the rotating member may further include a sliding groove (e.g., a first sliding groove 421d of FIG. 3C) disposed outside of the hinge bracket. According to an embodiment, the hinge structure may include a shaft (e.g., a first shaft 441a of FIG. 3C) rotatably coupled to the hinge bracket to be rotatable with respect to the hinge bracket. According to an embodiment, the hinge structure may include an arm (e.g., a first arm 442a of FIG. 3c) having one end (e.g., one end 442a-1 of FIG. 3C) facing the sliding groove and the other end (e.g., the other end 442a-2 of FIG. 3C) disposed on the shaft and rotatable with respect to the shaft. According to an embodiment, the hinge structure may further include a rotary pin (e.g., a first rotary pin 443a of FIG. 3C) movable within the sliding groove and coupling the arm and the rotating member. According to an embodiment, the rotary pin may rotate the arm by sliding in the sliding groove by a rotation of the rotating member.

According to an embodiment, the arm may include a driving cam (e.g., a first driving cam 442a-3 of FIG. 3C) disposed on the other end of the arm. According to an embodiment, the hinge structure may include a compressing member (e.g., a compressing member 444 of FIG. 3C) including a delivering cam (e.g., a first delivering cam 444a of FIG. 3C) corresponding to the driving cam and linearly movable with respect to the shaft. According to an embodiment, the hinge structure may include an elastic member (e.g., at least one elastic member 445 of FIG. 3C) disposed between the compressing member and the hinge bracket. According to an embodiment, the arm may press the elastic member by moving the compressing member in a direction close to the hinge bracket or in a direction away from the hinge bracket by rotating by the sliding of the rotary pin.

According to an embodiment, the hinge structure may further include a stopper (e.g., a stopper 446 of FIG. 3C) in contact with the other end of the elastic member opposite to one end of the elastic member in contact with the compression member and coupled to the shaft.

According to an embodiment, the shaft may further include a shaft gear (e.g., a first shaft gear 441c of FIG. 3C) rotatable by the rotation of the shaft. According to an embodiment, the hinge structure may further include an idle gear (e.g., at least one idle gear 447 of FIG. 3C) engaged with the shaft gear and rotatable by the shaft gear.

According to an embodiment, the supporting member further includes an operating opening (e.g., a plurality of operating openings 433 of FIG. 3C) overlapping the other end of the arm when the hinge structure is viewed from above.

According to an embodiment, an electronic device (e.g., an electronic device 300 of FIG. 3A) may comprise a first housing (e.g., a first housing 310 of FIG. 3A); a second housing rotatable with respect to the first housing; a hinge structure (e.g., a hinge structure 400 of FIGS. 3A, 3B, 3C, 3D, 3E, and 3F) disposed between the first housing and the second housing, and changeable to a folded state in which a one surface of the first housing faces a one surface of the second housing, or an unfolded state in which a direction the one surface of the first housing facing and a direction the one surface of the second housing facing are same each other; and a display (e.g., a display 330 of FIG. 3A) including a first display region (e.g., a first display region 331 of FIG. 3A) disposed on the first housing, a second display region (e.g., a second display region 332 of FIG. 3A) disposed on the second housing, and a third display region (e.g., a third display region 333 of FIG. 3A) disposed on the hinge structure. According to an embodiment, the hinge structure may include a hinge bracket (e.g., a hinge bracket 410 of FIG. 3C) including a rotary rail (e.g., a first rotary rail 411a of FIG. 3C) and a guide rail (e.g., a first guide rail 412a of FIG. 3C) spaced apart from the rotary rail. According to an embodiment, the hinge structure may include a rotating member (e.g., a first rotating member 421 of FIGS. 3C, 3D, 3E, and 3F) including a sliding pin (e.g., a first sliding pin 421c of FIGS. 3C, 3D, 3E, and 3F), coupled to the first housing and rotatable based on a first rotational axis (e.g., a first rotational axis a1 of FIGS. 4A, 4B, and 4C) along the rotary rail by the movement of the first housing. According to an embodiment, the hinge structure may include a supporting member (e.g., a first supporting member 431 of FIGS. 3C, 3D, 3E, and 3F) including a sliding opening (e.g., a first sliding opening 431b of FIGS. 3C, 3D, 3E, and 3F) slidable with respect to the sliding pin and a guide groove (e.g., a first guide groove 431a of FIGS. 3C, 3D, 3E, and 3F) guided by the guide rail, the supporting member supporting a one surface of the third display region. According to an embodiment, the supporting member may be rotatable along the guide rail based on a second rotational axis (e.g., a second rotational axis a2 of FIGS. 4A, 4B, and 4C) distinct from the first rotational axis by the sliding of the sliding opening. According to an embodiment, a width of one end (e.g., one end 431a-1 of FIGS. 4A, 4B, and 4C) of the guide groove may be bigger than a width of the other end (e.g., the other end 431a-2 of FIGS. 4A, 4B, and 4C) of the guide groove facing the one surface of the third display region.

According to an embodiment, a part of the third display region may be supported by the supporting member and may be inclined with respect to the first display region when the folded state.

According to an embodiment, the supporting member may move toward an outer surface of the hinge bracket when an angle between the first housing and the second housing is equal to or bigger than a designated angle.

According to an embodiment, a width of the guide groove may increase from the one end of the guide groove toward the other end of the guide groove.

According to an embodiment, the sliding pin may overlap the hinge bracket when the hinge structure is viewed from above.

According to an embodiment, the sliding opening may be bent to have a curvature.

The electronic device according to various embodiments disclosed in the present document may be various types of devices. The electronic device may include, for example, a portable communication device (e.g., a smartphone), a computer device, a portable multimedia device, a portable medical device, a camera, a wearable device, or a home appliance. The electronic device according to an embodiment of the present document is not limited to the above-described devices.

According to an example embodiment, there is provided an electronic device according to claim 1. Further embodiments are described by dependent claims 2-15.

The various embodiments and terms used herein are not intended to limit the technical features described herein to specific embodiments and should be understood to include various modifications, equivalents, or substitutes of the embodiment. With respect to the description of the drawings, similar reference numerals may be used for similar or related components. The singular form of the noun corresponding to the item may include one or more of the items unless clearly indicated differently in a related context. In this document, each of the phrases such as "A or B", "at least one of A and B", "at least one of A, B and C", "at least one of A, B, or C", and "at least one of A, B, or C" may include any one of the phrases together, or all possible combinations thereof. Terms such as "first", "second", or "second", or "second" may be used simply to distinguish a corresponding component from another corresponding component, and are not limited to other aspects (e.g., importance or order). When some (e.g., the first) component is referred to as "coupled" or "connected" in another (e.g., the second) component, with or without the term "functional" or "communicatively", it means that some of the components can be connected directly (e.g., wired), wirelessly, or through a third component.

The term "module" used in various embodiments of the present document may include a unit implemented in hardware, software, or firmware and be used interchangeably with terms such as logic, logic block, component, or circuitry, for example. The module may be a minimum unit or a part of the integrally configured component or the component that performs one or more functions. For example, according to an embodiment, the module may be implemented in the form of an application-specific integrated circuit (ASIC).

Various embodiments of the present document may be implemented as software (e.g., a program) including one or more instructions stored in a storage medium (or external memory) readable by a device (e.g., wearable device 100). For example, a processor (e.g., a processor) of a device (e.g., wearable device 100) may call and execute at least one of the one or more instructions stored from a storage medium. This makes it possible for the device to operate to perform at least one function according to at least one command called. The one or more instructions may include code generated by a compiler or code that may be executed by an interpreter. The device-readable storage medium may be provided in the form of a non-transitory storage medium. Here, the term 'non-transitory' only means that a storage medium is a device that is tangible and does not include a signal (e.g., electromagnetic wave), and the term does not distinguish between a case where data is semi-permanently stored and a case where it is temporarily stored.

According to an embodiment, a method according to various embodiments disclosed in the present document may be provided by being included in a computer program product. The computer program products may be traded between sellers and buyers as products. The computer program products may be distributed in the form of device-readable storage media (e.g., compact disc read only memory (CD-ROM), or distributed (e.g., downloaded or uploaded) directly or online through an application store (e.g., Play Store^{™}) or between two user devices (e.g., smartphones). In the case of online distribution, at least some of the computer program products may be temporarily stored or temporarily created on a device-readable storage medium such as a manufacturer's server, a server in an application store, or a memory in a relay server.

According to various embodiments, each of the above-described components (e.g., a module or a program) may include a single object or a plurality of obj ects, and some of the plurality of objects may be separated and disposed in other components. According to various embodiments, one or more components or operations of the above-described corresponding components may be omitted, or one or more other components or operations may be added. Alternatively, or additionally, a plurality of components (e.g., modules or programs) may be integrated into one component. In this case, the integrated component may perform one or more functions of each of the components in the same or similar manner as those performed by the corresponding component among the plurality of components before the integration. According to various embodiments, operations performed by a module, a program, or other components may be executed sequentially, in parallel, repeatedly, or heuristic, performed in a different order, omitted, or one or more other operations may be added.

## Claims

1. An electronic device (101, 200, 300) comprising:
a first housing (210, 310) including a first surface (211, 311) and a second surface (212, 312) opposite to the first surface;
a second housing (220, 320) including a third surface (221, 321) and a fourth surface (222, 322) opposite to the third surface;
a hinge structure (250, 400) rotatably connecting the first housing and the second housing; and
a display (230, 330) disposed on the first surface and the third surface across the hinge structure;
wherein the hinge structure includes:
a hinge bracket (410) including a rotary rail (411, 411a, 411b) and a guide rail (412, 412a, 412b) spaced apart from the rotary rail;
a rotating member (420, 421, 422) coupled to the first housing and including a sliding pin (421c, 422c); and
a supporting member (430, 431, 432) supporting one surface of the display, and including a sliding opening (431b, 432b) slidable with respect to the sliding pin, and a guide groove (431a, 432a) guided by the guide rail;
wherein the rotating member is rotatable along the rotary rail by a movement of the first housing, based on a first rotational axis (a1); and
wherein the supporting member is rotatable along the guide rail by a movement of the sliding opening, based on a second rotational axis (a2) distinct from the first rotational axis.

2. The electronic device of claim 1,
wherein a width of one end (431a-1) of the guide groove facing the one surface of the display is smaller than a width of the other end (431a-2) of the guide groove opposite to the one end of the guide groove.

3. The electronic device of claim 2,
wherein a width of the guide groove is configured to increase from the one end of the guide groove toward the other end of the guide groove.

4. The electronic device of claim according to any one of claims 1 to 3,
wherein the supporting member is configured to move toward an outer surface of the hinge bracket when an angle between the first housing and the second housing is equal to or bigger than a designated angle.

5. The electronic device of claim according to any one of claims 1 to 4,
wherein the first rotational axis is fixed while the rotating member rotates, and
wherein the second rotational axis is changed according to a movement of the supporting member.

6. The electronic device of claim according to any one of claims 1 to 5,
wherein the sliding opening is bent to have a curvature.

7. The electronic device of claim according to any one of claims 1 to 6,
wherein the sliding pin is overlapped to the hinge bracket when the hinge structure is viewed from above.

8. The electronic device of claim according to any one of claims 1 to 7,
wherein the rotating member is rotatable with respect to the hinge bracket within a first angle range, and
wherein the supporting member is rotatable with respect to the hinge bracket within a second angle range bigger than the first angle range.

9. The electronic device of claim according to any one of claims 1 to 8,
wherein the rotating member further includes a rotary groove (421b, 422b) configured to have a constant curvature along the rotary rail and to be guidable by the rotary rail.

10. The electronic device of claim according to any one of claims 1 to 9,
wherein the supporting member further includes:
a supporting plate (431c, 432c), in which the guide groove is disposed, configured to support the one surface of the display; and
a connecting member (431d, 432d), in which the sliding opening is disposed, coupled to the supporting plate to be movable together with the supporting plate.

11. The electronic device of claim 10,
wherein a one end of the sliding opening disposed in the connecting member is opened toward to the supporting plate.

12. The electronic device of claim according to any one of claims 1 to 11,
wherein the rotating member further includes a sliding groove (421d, 422d) disposed outside of the hinge bracket,
wherein the hinge structure further includes:
a shaft (441, 441a, 441b) rotatably coupled to the hinge bracket to be rotatable with respect to the hinge bracket;
an arm (442, 442a, 442b) rotatable with respect to the shaft, one end of the arm configured to face the sliding groove, and the other end of the arm disposed on the shaft; and
a rotary pin (443a, 443b) movable within the sliding groove and configured to couple the arm and the rotating member; and
wherein the rotary pin is configured to rotate the arm by sliding in the sliding groove by a rotation of the rotating member.

13. The electronic device of claim 12,
wherein the arm includes a driving cam (442a-3, 442b-3) disposed on the other end of the arm,
wherein the hinge structure further includes:
a compressing member (444) including a delivering cam (444a, 444b) corresponding to the driving cam and linearly movable with respect to the shaft; and
an elastic member (445) disposed between the compressing member and the hinge bracket, and
wherein the arm is configured to presses the elastic member by moving the compressing member in a direction close to the hinge bracket or in a direction away from the hinge bracket when rotated by the sliding of the rotary pin.

14. The electronic device of claim 12 or claim 13,
wherein the shaft further includes a shaft gear (441c, 441d) rotatable by the rotation of the shaft, and
wherein the hinge structure further includes an idle gear (447) engaged with the shaft gear and rotatable by the shaft gear.

15. The electronic device of claim according to any one of claims 12 to 14,
wherein the supporting member further includes an operating opening (433, 433b) configured to overlap the other end of the arm when the hinge structure is viewed from above.

## Patentansprüche

1. Elektronische Vorrichtung (101, 200, 300), umfassend:
ein erstes Gehäuse (210, 310), das eine erste Oberfläche (211, 311) und eine zweite Oberfläche (212, 312) gegenüber der ersten Oberfläche einschließt;
ein zweites Gehäuse (220, 320), das eine dritte Oberfläche (221, 321) und eine vierte Oberfläche (222, 322) gegenüber der dritten Oberfläche einschließt;
eine Schamierstruktur (250, 400), die das erste Gehäuse und das zweite Gehäuse drehbar verbindet; und
eine Anzeige (230, 330), die an der ersten Oberfläche und der dritten Oberfläche über die Schamierstruktur angeordnet ist;
wobei die Scharnierstruktur Folgendes einschließt:
eine Scharnierhalterung (410), die eine Drehschiene (411, 411a, 411b) und eine von der Drehschiene beabstandete Führungsschiene (412, 412a, 412b) einschließt;
ein sich drehendes Element (420, 421, 422), das an das erste Gehäuse gekoppelt ist und einen Schiebestift (421c, 422c) einschließt; und
ein Stützelement (430, 431, 432), das eine Oberfläche der Anzeige stützt und eine Schiebeöffnung (431b, 432b), die in Bezug auf den Schiebestift verschiebbar ist, und eine Führungsnut (431a, 432a), die durch die Führungsschiene geführt ist, einschließt;
wobei das sich drehende Element entlang der Drehschiene durch eine Bewegung des ersten Gehäuses basierend auf einer ersten Drehachse (a1) drehbar ist; und
wobei das Stützelement entlang der Führungsschiene durch eine Bewegung der Schiebeöffnung basierend auf einer zweiten Drehachse (a2), die sich von der ersten Drehachse unterscheidet, drehbar ist.

2. Elektronische Vorrichtung nach Anspruch 1,
wobei eine Breite eines Endes (431a-1) der Führungsnut, das der einen Oberfläche der Anzeige zugewandt ist, kleiner ist als eine Breite des anderen Endes (431a-2) der Führungsnut gegenüber dem einen Ende der Führungsnut.

3. Elektronische Vorrichtung nach Anspruch 2,
wobei eine Breite der Führungsnut dazu konfiguriert ist, von dem einen Ende der Führungsnut in Richtung des anderen Endes der Führungsnut zuzunehmen.

4. Elektronische Vorrichtung nach Anspruch gemäß einem der Ansprüche 1 bis 3,
wobei das Stützelement dazu konfiguriert ist, sich in Richtung einer Außenoberfläche der Scharnierhalterung zu bewegen, wenn ein Winkel zwischen dem ersten Gehäuse und dem zweiten Gehäuse gleich oder größer als ein bezeichneter Winkel ist.

5. Elektronische Vorrichtung nach Anspruch gemäß einem der Ansprüche 1 bis 4,
wobei die erste Drehachse fixiert ist, während sich das sich drehende Element dreht, und
wobei die zweite Drehachse gemäß einer Bewegung des Stützelements geändert wird.

6. Elektronische Vorrichtung nach Anspruch gemäß einem der Ansprüche 1 bis 5,
wobei die Schiebeöffnung gebogen ist, sodass sie eine Krümmung aufweist.

7. Elektronische Vorrichtung nach Anspruch gemäß einem der Ansprüche 1 bis 6,
wobei der Schiebestift mit der Scharnierhalterung überlappt ist, wenn die Scharnierstruktur von oben betrachtet wird.

8. Elektronische Vorrichtung nach Anspruch gemäß einem der Ansprüche 1 bis 7,
wobei das sich drehende Element in Bezug auf die Scharnierhalterung innerhalb eines ersten Winkelbereichs drehbar ist und
wobei das Stützelement in Bezug auf die Scharnierhalterung innerhalb eines zweiten Winkelbereichs drehbar ist, der größer als der erste Winkelbereich ist.

9. Elektronische Vorrichtung nach Anspruch gemäß einem der Ansprüche 1 bis 8,
wobei das sich drehende Element ferner eine Drehnut (421b, 422b) einschließt, die dazu konfiguriert ist, eine konstante Krümmung entlang der Drehschiene aufzuweisen und durch die Drehschiene führbar zu sein.

10. Elektronische Vorrichtung nach Anspruch gemäß einem der Ansprüche 1 bis 9,
wobei das Stützelement ferner Folgendes einschließt:
eine Stützplatte (431c, 432c), in der die Führungsnut angeordnet ist und die dazu konfiguriert ist,
die eine Oberfläche der Anzeige zu stützen; und
ein Verbindungselement (431d, 432d), in dem die Schiebeöffnung angeordnet ist und das an die Stützplatte gekoppelt ist, um zusammen mit der Stützplatte bewegbar zu sein.

11. Elektronische Vorrichtung nach Anspruch 10,
wobei ein Ende der Schiebeöffnung, die in dem Verbindungselement angeordnet ist, in Richtung der Stützplatte geöffnet ist.

12. Elektronische Vorrichtung nach Anspruch gemäß einem der Ansprüche 1 bis 11,
wobei das sich drehende Element ferner eine Schiebenut (421d, 422d) einschließt, die außerhalb der Scharnierhalterung angeordnet ist,
wobei die Scharnierstruktur ferner Folgendes einschließt:
eine Welle (441, 441a, 441b), die drehbar an die Scharnierhalterung gekoppelt ist, um in Bezug auf die Scharnierhalterung drehbar zu sein;
einen Arm (442, 442a, 442b), der in Bezug auf die Welle drehbar ist, wobei ein Ende des Arms dazu konfiguriert ist, der Schiebenut zugewandt zu sein, und das andere Ende des Arms an der Welle angeordnet ist; und
einen Drehstift (443a, 443b), der innerhalb der Schiebenut bewegbar ist und dazu konfiguriert ist, den Arm und das sich drehende Element zu koppeln; und
wobei der Drehstift dazu konfiguriert ist, den Arm durch Verschieben in der Schiebenut durch eine Drehung des sich drehenden Elements zu drehen.

13. Elektronische Vorrichtung nach Anspruch 12,
wobei der Arm einen Antriebsnocken (442a-3, 442b-3) einschließt, der an dem anderen Ende des Arms angeordnet ist,
wobei die Scharnierstruktur ferner Folgendes einschließt:
ein Kompressionselement (444), das einen Abgabenocken (444a, 444b) einschließt, der dem Antriebsnocken entspricht und in Bezug auf die Welle linear bewegbar ist; und
ein elastisches Element (445), das zwischen dem Kompressionselement und der Scharnierhalterung angeordnet ist, und
wobei der Arm dazu konfiguriert ist, das elastische Element durch Bewegen des Kompressionselements in eine Richtung nahe der Scharnierhalterung oder in eine Richtung weg von der Scharnierhalterung zu drücken, wenn er durch das Verschieben des Drehstifts gedreht wird.

14. Elektronische Vorrichtung nach Anspruch 12 oder Anspruch 13,
wobei die Welle ferner ein Wellenzahnrad (441c, 441d) einschließt, das durch die Drehung der Welle drehbar ist, und
wobei die Scharnierstruktur ferner ein Leerlaufzahnrad (447) einschließt, das mit dem Wellenzahnrad in Eingriff steht und durch das Wellenzahnrad drehbar ist.

15. Elektronische Vorrichtung nach Anspruch gemäß einem der Ansprüche 12 bis 14,
wobei das Stützelement ferner eine Bedienöffnung (433, 433b) einschließt, die dazu konfiguriert ist, das andere Ende des Arms zu überlappen, wenn die Scharnierstruktur von oben betrachtet wird.

## Revendications

1. Dispositif électronique (101, 200, 300) comprenant :
un premier boîtier (210, 310) comprenant une première surface (211, 311) et une deuxième surface (212, 312) opposée à la première surface ;
un second boîtier (220, 320) comprenant une troisième surface (221, 321) et une quatrième surface (222, 322) opposée à la troisième surface ;
une structure charnière (250, 400) reliant de manière rotative le premier boîtier et le second boîtier ; et
un dispositif d'affichage (230, 330) disposé sur la première surface et la troisième surface à travers la structure charnière ;
ladite structure charnière comprenant :
un support de charnière (410) comprenant un rail rotatif (411, 411a, 411b) et un rail de guidage (412, 412a, 412b) espacé du rail rotatif ;
un élément rotatif (420, 421, 422) couplé au premier boîtier et comprenant une broche coulissante (421c, 422c) ; et
un élément de support (430, 431, 432) supportant une surface du dispositif d'affichage, et comprenant une ouverture coulissante (431b, 432b) pouvant coulisser par rapport à la broche coulissante, et une rainure de guidage (431a, 432a) guidée par le rail de guidage ;
ledit élément rotatif pouvant tourner le long du rail rotatif par un mouvement du premier boîtier, sur la base d'un premier axe de rotation (a1) ; et
ledit élément de support pouvant tourner le long du rail de guidage par un mouvement de l'ouverture coulissante, sur la base d'un second axe de rotation (a2) distinct du premier axe de rotation.

2. Dispositif électronique de la revendication 1,
une largeur d'une extrémité (431a-1) de la rainure de guidage faisant face à la surface du dispositif d'affichage étant inférieure à une largeur de l'autre extrémité (431a-2) de la rainure de guidage opposée à la première extrémité de la rainure de guidage.

3. Dispositif électronique de la revendication 2,
une largeur de la rainure de guidage étant conçue pour augmenter à partir de l'extrémité de la rainure de guidage vers l'autre extrémité de la rainure de guidage.

4. Dispositif électronique de revendications selon l'une quelconque des revendications 1 à 3, ledit élément de support étant conçu pour se déplacer vers une surface externe du support de charnière lorsqu'un angle entre le premier boîtier et le second boîtier est supérieur ou égal à un angle désigné.

5. Dispositif électronique de revendications selon l'une quelconque des revendications 1 à 4, ledit premier axe de rotation étant fixe pendant que l'élément rotatif tourne, et ledit second axe de rotation étant modifié selon un mouvement de l'élément de support.

6. Dispositif électronique de revendications selon l'une quelconque des revendications 1 à 5, ladite ouverture coulissante étant courbée pour comporter une courbure.

7. Dispositif électronique de revendications selon l'une quelconque des revendications 1 à 6, ladite broche coulissante chevauchant le support de charnière lorsque la structure de charnière est vue du dessus.

8. Dispositif électronique de revendications selon l'une quelconque des revendications 1 à 7, ledit élément rotatif pouvant tourner par rapport au support de charnière dans une première plage d'angles, et
ledit élément de support pouvant tourner par rapport au support de charnière dans une seconde plage d'angles supérieure à la première plage d'angles.

9. Dispositif électronique de revendications selon l'une quelconque des revendications 1 à 8, ledit élément rotatif comprenant en outre une rainure rotative (421b, 422b) conçue pour comporter une courbure constante le long du rail rotatif et pour pouvoir être guidée par le rail rotatif.

10. Dispositif électronique de revendications selon l'une quelconque des revendications 1 à 9, ledit élément de support comprenant en outre :
une plaque de support (431c, 432c), ladite rainure de guidage étant disposée, conçue pour supporter la surface du dispositif d'affichage ; et
un élément de connexion (431d, 432d), dans lequel l'ouverture coulissante est disposée, couplé à la plaque de support pour être mobile conjointement avec la plaque de support.

11. Dispositif électronique de la revendication 10,
une extrémité de l'ouverture coulissante disposée dans l'élément de connexion étant ouverte vers la plaque de support.

12. Dispositif électronique de revendications selon l'une quelconque des revendications 1 à 11,
ledit élément rotatif comprenant en outre une rainure coulissante (421d, 422d) disposée à l'extérieur du support de charnière,
ladite structure charnière comprenant en outre :
un arbre (441, 441a, 441b) couplé rotatif au support de charnière pour pouvoir tourner par rapport au support de charnière ;
un bras (442, 442a, 442b) pouvant tourner par rapport à l'arbre, une extrémité du bras étant conçue pour faire face à la rainure coulissante, et l'autre extrémité du bras étant disposée sur l'arbre ; et
une broche rotative (443a, 443b) mobile à l'intérieur de la rainure coulissante et conçue pour coupler le bras et l'élément rotatif ; et
ladite broche rotative étant conçue pour faire tourner le bras en coulissant dans la rainure coulissante par une rotation de l'élément rotatif.

13. Dispositif électronique de la revendication 12,
ledit bras comprenant une came d'entraînement (442a-3, 442b-3) disposée sur l'autre extrémité du bras,
ladite structure charnière comprenant en outre :
un élément de compression (444) comprenant une came de distribution (444a, 444b) correspondant à la came d'entraînement et mobile linéairement par rapport à l'arbre ; et
un élément élastique (445) disposé entre l'élément de compression et le support de charnière, et ledit bras étant conçu pour presser l'élément élastique en déplaçant l'élément de compression dans une direction proche du support de charnière ou dans une direction s'éloignant du support de charnière lorsqu'il est tourné par le coulissement de la broche rotative.

14. Dispositif électronique de la revendication 12 ou de la revendication 13,
ledit arbre comprenant en outre un engrenage d'arbre (441c, 441d) pouvant tourner sous l'effet de la rotation de l'arbre, et
ladite structure charnière comprenant en outre un engrenage fou (447) en prise avec l'engrenage d'arbre et pouvant être mis en rotation par l'engrenage d'arbre.

15. Dispositif électronique de revendications selon l'une quelconque des revendications 12 à 14, ledit élément de support comprenant en outre une ouverture de fonctionnement (433, 433b) conçue pour chevaucher l'autre extrémité du bras lorsque la structure charnière est vue du dessus.
